(19) Europäisches Patentamt
European Patent Office
Office européen des brevets

(11) Veröffentlichungsnummer: **0 253 765**
**B1**

(12) # EUROPÄISCHE PATENTSCHRIFT

(45) Veröffentlichungstag der Patentschrift: **18.04.90**

(51) Int. Cl.⁴: **C08G 73/10**, G03F 7/038

(21) Anmeldenummer: **87810357.1**

(22) Anmeldetag: **24.06.87**

(54) **Diamino-9,10-dihydroanthracene und davon abgeleitete Polyamidsäure-(ester) und Polyimide.**

(30) Priorität: **30.06.86 CH 2618/86**

(43) Veröffentlichungstag der Anmeldung: **20.01.88 Patentblatt 88/3**

(45) Bekanntmachung des Hinweises auf die Patenterteilung: **18.04.90 Patentblatt 90/16**

(84) Benannte Vertragsstaaten: **BE CH DE ES FR GB IT LI NL SE**

(56) Entgegenhaltungen:
**EP-A- 0 132 221**
**EP-A- 0 162 017**

(73) Patentinhaber: **CIBA-GEIGY AG, Klybeckstrasse 141, CH-4002 Basel(CH)**

(72) Erfinder: **Pfeifer, Josef, Dr., Brunnmattstrasse 32, CH-4106 Therwil(CH)**
Erfinder: **Duthaler, Rudolf, Dr., Girenhaldenweg 17, CH-4126 Bettingen(CH)**

**EP 0 253 765 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft Polyamidsäure(ester) und Polyimide enthaltend Struktureinheiten gewisser 9,10-Dihydroanthracene, die Diamino-9,10-dihydroanthracenzwischenprodukte, Beschichtungsmittel enthaltend diese Polymeren, die Verwendung von diesen Polymeren zur Herstellung von hitzebeständigen Ueberzügen, Folien und Reliefstrukturen sowie die durch Strahlungsvernetzung dieser Polymeren erhältlichen Ueberzüge, Folien und Reliefstrukturen.

Polyimide und deren Polyamidsäurevorläufer eignen sich bekanntermassen zur Herstellung von hochhitzebeständigen Ueberzügen. Insbesondere auf dem Gebiet der Elektronikindustrie sind lösliche und gleichzeitig strahlungsvernetzbare Polyimide gefragt, die dort beispielsweise als Maskenmaterialien oder als Schutzüberzüge Verwendung finden. Solche Polyimide sind beispielsweise in der EP-A 134,752 beschrieben. Ferner sind aus den EP-A 132,221 und 162,017 lösliche und gleichzeitig autophotovernetzbare Polyimide bekannt, die sich von aromatischen Diaminen ableiten, welche in beiden Orthostellungen zu mindestens einer Aminogruppe substituiert sind. Die Polymeren besitzen einen Mindestanteil an Benzophenontetracarbonsäureeinheiten oder an Einheiten anderer aromatischer Tetracarbonsäuren, bei denen die carboxylgruppenhaltigen aromatischen Reste über Carbonylgruppen an weitere aromatische Reste gebunden sind.

Der Einbau von Alkylgruppen in den Diaminteil eines Polyimids führt in der Regel zu einer Verbesserung der Löslichkeit des Polymeren; gleichzeitig verringert sich allerdings die thermooxidative Stabilität. Für die oben erwähnten Zwecke sind möglichst hohe Temperaturbeständigkeiten gefragt. Es wurde jetzt gefunden, dass sich durch den Einbau gewisser 9,10-Dihydroanthraceneinheiten in Polyimide, deren Polyamidsäurervorläufer oder davon abgeleitete Ester eine verbesserte Stabilität bei hohen Temperaturen, insbesondere gegenüber thermoxidativem Abbau, erzielen lässt.

Die vorliegende Erfindung betrifft Homo- oder Copolyamidsäure(ester) und davon abgeleitete Homo- oder Copolyimide enthaltend mindestens 5 Mol% Struktureinheiten der Formel I und/oder II

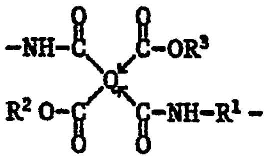 (I), 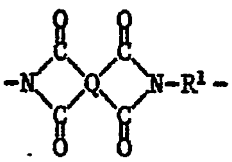 (II),

worin Q ein unsubstituierter oder substituierter vierwertiger aromatischer Rest ist, an den je zwei Carbonylgruppen in ortho- oder peri-Position gebunden sind, $R^1$ ausgewählt wird aus den Resten der Formeln III, IV oder V

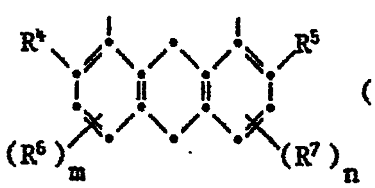 (III), 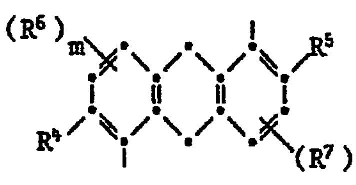 (IV),

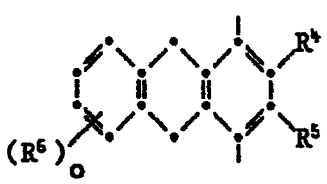 (V),

$R^2$, $R^3$, $R^4$ und $R^5$ unabhängig voneinander Wasserstoff, Alkyl, Cycloalkyl, gegebenenfalls substituiertes Aryl oder Aralkyl bedeuten,
$R^6$ und $R^7$ unabhängig voneinander Aryl oder Halogen darstellen,
m und n unabhängig voneinander 0, 1 oder 2 sind, und
o 0, 1, 2, 3 oder 4 bedeutet, wobei die Reste $R^1$ bis $R^7$ innerhalb der gegebenen Definitionen unterschiedliche Bedeutungen annehmen können und die Pfeile in Formel I für Stellungsisomerie stehen.

Q als unsubstituierter oder substituierter vierwertiger aromatischer Rest besitzt in der Regel 6 bis 30, besonders 6 bis 20, C-Atome und gegebenenfalls ein oder zwei Heteroatome, wie beispielsweise O, N oder S.
Bei allfälligen Substituenten am Rest Q handelt es sich vorzugsweise um Alkylgruppen, besonders um Methyl, oder um Halogenatome, besonders um Chlor oder Brom. Bevorzugt werden unsubstituierte Reste Q.

Bevorzugte Reste Q sind in der EP-A 132,221 beschrieben.
Zu den besonders bevorzugten Resten Q dieses Types zählen beispielsweise diejenigen der Formeln

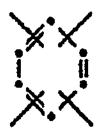 , 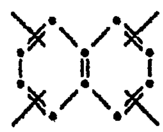 , 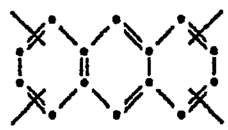 ,

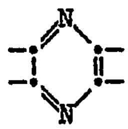 , 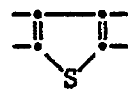 , 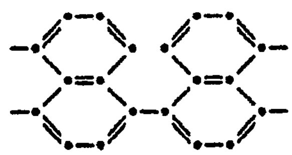 ,

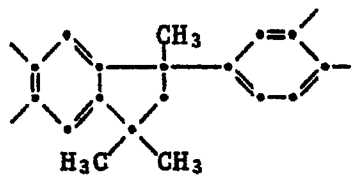 , 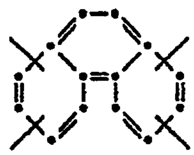 und

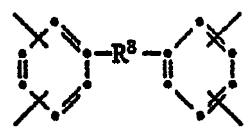 ,

worin $R^8$ eine direkte Bindung oder ein Brückengruppe der Formeln -O-, -S-, $-SO_2-$, $-CH_2-$, $-C(CH_3)_2-$ oder -CO- ist.

Besonders bevorzugte Reste Q dieses Typs leiten sich von Benzophenontetracarbonsäure, insbesondere vom 3,3',4,4'- Derivat, ab. Weitere bevorzugte Reste Q sind in der EP-A 162,017 beschrieben. Bei diesen Resten handelt es sich insbesondere um Gruppen der Formel VI

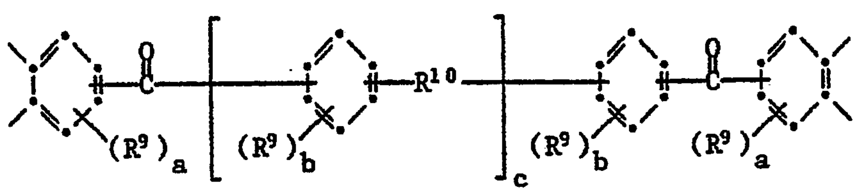 (VI) ,

worin $R^9$ für $C_1$-$C_6$-Alkyl, $C_1$-$C_6$-Alkoxy, $C_1$-$C_6$-Alkylthio, Phenyl, Phenyloxy oder Phenylthio steht,
$R^{10}$ eine direkte Bindung oder ein Brückengruppe der Formeln -O-, -S-, $-SO_2-$, $-CH_2-$, $-C(CH_3)_2-$ oder -CO- bedeutet,
a für 0, 1, 2 oder 3, b für 0, 1, 2, 3 oder 4 und c für 0, 1, 2, 3, 4 oder 5 steht, und, wenn a und b 2 sind, beide $R^9$ zusätzlich zu den oben gegebenen Definitionen auch in o-Stellung zueinander gebunden sind und zusammen -CH=CH-CH=CH- bedeuten. Der Index c ist vorzugsweise 0. Die Indizes a und b sind vorzugsweise 0 oder 1.

Besonders bevorzugte Strukturelemente dieses Typs entsprechen der Formel VIa und VIb

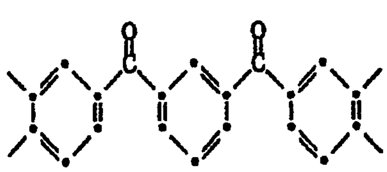 (VIa), 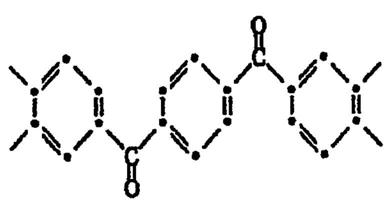 (VIb).

Weitere bevorzugte Reste Q sind in der EP-A 181,837 beschrieben. Dabei handelt es sich bevorzugt um Strukturen der Formeln VIII, IX, X und XI

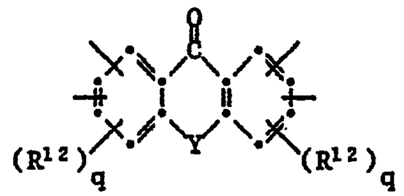 (VIII), 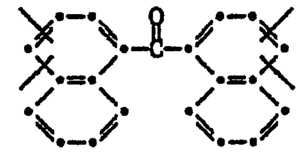 (IX),

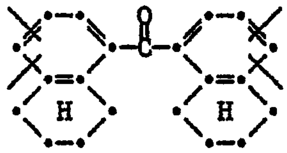 (X), 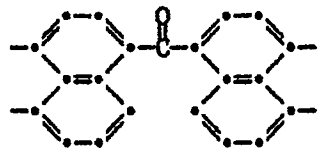 (XI),

in denen die freien Bindungen in Orthostellung zueinander stehen und Y eine direkte Bindung, $-CH_2-$, $-(CH_2)_2-$, -O-, -S-, $-SO_2-$, -CO-, $-NR^{11}-$ oder $-CR^{13}R^{14}-$ bedeutet, wobei $R^{11}$ und $R^{13}$ ein Wasserstoffatom, $C_1$-$C_8$-Alkyl oder Phenyl sind und $R^{14}$ die Bedeutung von $R^{13}$ mit Ausnahme der Bedeutung eines Wasserstoffatomes hat, $R^{12}$ für $C_1$-$C_6$-Alkyl, $C_1$-$C_6$-Alkoxy oder Phenoxy und q = 0, 1 oder 2 ist. q ist bevorzugt 0.

In einer besonders bevorzugten Ausführungsform der Reste dieses Typs handelt es sich um Strukturen der Formeln VIIIa, VIIIb, VIIIc oder VIIId, insbesondere um die 3,3',4,4'-Derivate dieser Reste,

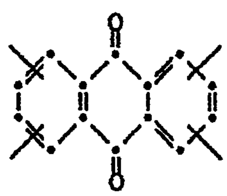 (VIIIa), 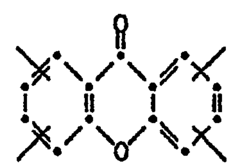 (VIIIb),

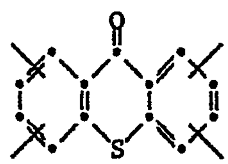 (VIIIc), 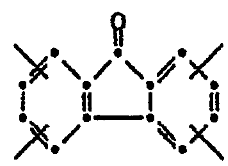 (VIIId).

Bedeuten irgendwelche Reste Alkyl, so handelt es sich dabei in der Regel um $C_1$-$C_{20}$Alkyl, bevorzugt um $C_1$-$C_6$Alkyl. Die Alkylreste können verzweigt oder unverzweigt sein. Bevorzugt werden unverzweigte Reste.

Beispiele für $C_1$-$C_{20}$Alkyl sind Methyl, Ethyl, n-Propyl, Isopropyl, n-Butyl, sek.Butyl, tert.Butyl, n-Pentyl, Isoamyl, n-Hexyl, n-Heptyl, n-Octyl, 2-Ethylhexyl, n-Nonyl, n-Decyl, n-Dodecyl, n-Tetradecyl, n-Hexadecyl, n-Octadecyl oder n-Eicosyl.

Bevorzugt werden Methyl, Ethyl, n-Propyl, Isopropyl, n-Butyl und n-Hexyl, insbesondere jedoch Methyl.

Bedeuten irgendwelche Reste Cycloalkyl, so handelt es sich dabei in der Regel um $C_5$-$C_7$Cycloalkyl. Beispiele für solche Reste sind Cyclopentyl, Cyclohexyl oder Cycloheptyl. Bevorzugt wird Cyclohexyl.

Beispiele für Arylreste sind Phenyl oder Naphthyl. Substituierte Arylgruppen können beispielsweise Alkylgruppen, insbesondere Methyl, Halogenatome, insbesondere Chlor, Nitrogruppen oder Cyanogruppen als Substituenten tragen. Spezifische Beispiele für substituierte Arylreste sind o-, m- oder p-Tolyl, Xylyl oder Chorphenyl. Bevorzugt wird Phenyl.

Handelt es sich bei irgendwelchen Resten um Aralkyl, so sind dies in der Regel $C_7$-$C_{14}$Aralkylgruppen. Beispiele dafür sind Benzyl, α-Methylbenzyl, α,α-Dimethylbenzyl oder 4-Methylbenzyl. Bevorzugt wird Benzyl.

Bedeuten irgendwelche Reste Halogen, so handelt es sich dabei um Fluor, Chlor, Brom und Iod. Bevorzugt werden Chlor und Brom, insbesondere Chlor.

$R^9$, $R^{11}$, $R^{12}$, $R^{13}$ und $R^{14}$ sind als $C_1$-$C_6$-Alkyl beispielsweise Methyl, Ethyl, n-Propyl, n-Butyl oder n-Hexyl. Bevorzugt wird Methyl.

$R^9$ und $R^{12}$ sind als $C_1$-$C_6$Alkoxy beispielsweise Methoxy, Ethoxy, n-Propoxy, n-Butoxy oder n-Hexoxy. Bevorzugt wird Methoxy.

$R^9$ ist als $C_1$-$C_6$Alkylthio beispielsweise Methylthio, Ethylthio, n-Propylthio, n-Butylthio oder n-Hexylthio. Bevorzugt wird Methylthio.

Die Indizes m und n sind vorzugsweise 0 oder 1, besonders bevorzugt 0. Der Index o ist vorzugsweise 0, 1 oder 2, insbesondere bevorzugt 0.

Die Reste $R^1$ mit den Formeln III oder IV werden bevorzugt.

Unter den 9,10-Dihydroanthracenresten $R^1$ werden die unsubstituierten oder diejenigen mit höchstens zwei $C_1$-$C_6$-Alkylgruppen, insbesondere diejenigen mit höchstens zwei Methylgruppen, bevorzugt.

$R^2$ und $R^3$ sind vorzugsweise Wasserstoff oder $C_1$-$C_6$-Alkyl, insbesondere Wasserstoff, Methyl oder Ethyl.

Homo- und Copolyimide enthaltend mindestens 30 Mol%, bezogen auf das Gesamtpolymere, an Struktureinheiten der Formel II werden bevorzugt. Besonders bevorzugt werden Homo- und Copolyimide enthaltend mindestens 30 Mol%, bezogen auf das Gesamtpolymere, an Struktureinheiten der Formel II, worin die Reste $R^1$ unsubstituiert sind oder höchstens zwei $C_1$-$C_6$-Alkylsubstituenten tragen.

Ganz besonders bevorzugt werden Homo- oder Copolyimide bestehend aus wiederkehrenden Struktureinheiten der Formel II.

Die Homopolyimide mit unsubstituierten 9,10-Dihydroanthracenresten sind in der Regel unlöslich und zeichnen sich durch eine besonders hohe thermooxidative Stabilität aus.

Die erfindungsgemässen Copolyamidsäure(ester) und die Copolyimide können neben den 9,10-Dihydroanthracenresten $R^1$ noch weitere Reste von Diaminen $R'^1$ enthalten, solange die Mindestmenge von Struktureinheiten der Formeln I und/oder II gegeben ist.

Solche Reste $R'^1$ leiten sich im allgemeinen von zweiwertigen unsubstituierten oder substituierten aliphatischen, gegebenenfalls durch Heteroatome, aromatische, heterocyclische oder cycloaliphatische Gruppen unterbrochenen aliphatischen Resten, von unsubstituierten oder substituierten cycloaliphatischen, aromatischen, heterocyclischen oder araliphatischen Gruppen ab. Beispiele für solche Diaminreste findet man in der EP-A 134,752.

Zu den bevorzugten Cokomponenten $R'^1$ zählen aromatische Reste organischer Diamine, insbesondere diejenigen, worin der aromatische Rest in zwei Orthostellungen zu mindestens einer Aminogruppe durch Alkyl, Cycloalkyl, Alkoxy, Alkoxyalkyl oder Aralkyl substituiert ist oder worin zwei benachbarte C-Atome des aromatischen Restes durch Alkylen substituiert sind. Diamine dieses Typs sind in der EP-A 132,221 beschrieben.

Besonders bevorzugte Diamine entsprechen den Formeln III und IIIa der EP-A 132,221.

Weitere bevorzugte Reste $R'^1$ sind aromatisch und besitzen einen Alkylrest in ortho-Position zu mindestens einer Aminogruppe. Solche Reste sind in der EP-A 134,752 beschrieben.

Eine besonders bevorzugte Gruppe von Resten $R'^1$ entspricht den Formeln

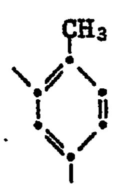 , 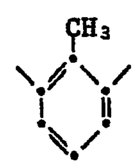 , 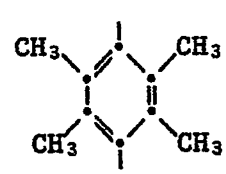 , 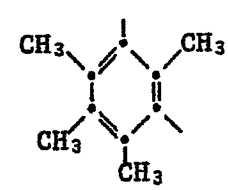 ,

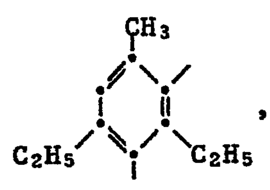 , 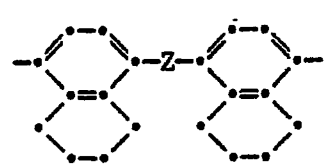 und 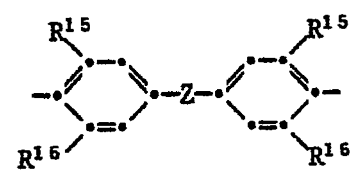 ,

worin Z eine direkte Bindung, -O- und insbesondere $-CH_2-$ bedeutet, $R^{15}$ Methyl, Ethyl oder Isopropyl ist und $R^{16}$ Methyl, Ethyl, Isopropyl und insbesondere Wasserstoff ist.

Ganz besonders bevorzugt sind Reste, worin Z $-CH_2-$ ist, $R^{15}$ Isopropyl bedeutet und $R^{16}$ Wasserstoff ist.

Durch die Einführung substituierter Diaminreste, bevorzugt aliphatisch substituierter aromatischer Reste, gelingt es oft die Löslichkeit der Polyimide (in organischen Lösungsmitteln) zu erhöhen oder herzustellen. Die Zusammenhänge zwischen Struktur und Löslichkeit von Polyimiden sind allerdings noch nicht restlos geklärt; es muss daher dem Fachmann überlassen werden mittels Routinetests abzuklären, ob die Einführung eines bestimmten Diaminrestes in ein Polyimid zu einer Erhöhung der Löslichkeit führt oder nicht.

Besonders bevorzugt werden Homo- oder Copolyimide enthaltend mindestens 30 Mol%, bezogen auf das Gesamtpolymere, an Struktureinheiten der Formel II und enthaltend ausschliesslich aromatische Diaminreste, die sich ableiten von unsubstituierten oder höchstens zweifach $C_1$-$C_6$-alkylsubstituierten Resten der Formeln III, IV oder V und gegebenenfalls weiteren unsubstituierten oder höchstens vierfach $C_1$-$C_6$-alkylsubstituierten aromatischen Diaminresten, bevorzugt von Diaminresten mit höchstens vier $C_1$-$C_6$-Alkylgruppen in den ortho-Positionen zu den Stickstoffatomen, wobei der Anteil der alkylsubstituierten Diaminreste mindestens so gross gewählt wird, dass die Polymeren sich in aprotischen, organischen Lösungsmitteln lösen. Ein Polyimid wird dann als ausreichend löslich angesehen, wenn es sich zu wenigstens 0,5 g, bevorzugt zu 5 g, pro 100 ml Lösungsmittel löst. Für viele Zwecke reichen bereits geringere Löslichkeiten aus. Bevorzugte Lösungsmittel sind Dimethylformamid, Dimethylacetamid, Dimethylsulfoxid, N-Methylpyrrolidon, Hexamethylphosphorsäureamid oder γ-Butyrolacton.

Besonders bevorzugt werden lösliche (Co)polyimide, wie oben definiert, enthaltend 30-100 Mol%, insbesondere 50-100 Mol%, der Strukturelemente der Formel II, worin Q ein vierwertiger diarylketonhaltiger Rest ist.

Der Begriff "diarylketonhaltiger Rest" umfasst alle Reste, die im weitesten Sinne eine Aryl-CO-Aryl Einheit aufweisen. Unter die Definition fallen also auch chinoide Systeme, wie beispielsweise Anthrachinonreste.

Ganz besonders bevorzugt werden lösliche (Co)polyimide, wie oben definiert, enthaltend 30-100 Mol%, insbesondere 50-100 Mol%, der Strukturelemente der Formel II, worin Q sich ableitet von den 3,3',4,4'-Derivaten der Benzophenon-, Anthrachinon-, Xanthon- oder Thioxanthontetracarbonsäure oder von einer Mischung dieser Säuren.

Eine weitere bevorzugte Gruppe der erfindungsgemässen Polymeren sind (Co)polyamidsäure(ester) enthaltend 30-100 Mol%, bezogen auf das Gesamtpolymer, der Strukturelemente der Formel I, worin $R^2$ und $R^3$ unabhängig voneinander Wasserstoff oder Alkyl sind, insbesondere jedoch jeweils Wasserstoff oder Methyl oder Ethyl bedeuten.

Die erfindungsgemässen Polyimide, Polyamidsäuren, Polyamidsäureester oder teilweise cyclisierten Polyamidsäuren, d.h. Verbindungen enthaltend Struktureinheiten I und II, weisen mittlere Molekulargewichte (Gewichtsmittel $\bar{M}w$) von mindestens 2 000, vorzugsweise mindestens 5 000 auf. Die obere Grenze richtet sich im wesentlichen nach Eigenschaften, die die Verarbeitbarkeit bestimmen, wie z.B. deren Löslichkeit. Sie kann bis zu 500 000, vorzugsweise 100 000 und besonders bis zu 60 000 betragen. Es kann sich ferner um statistische Polyimide bzw. Polyamidsäure(derivate) oder um Blockpolyimide bzw. Polyamidsäure(derivate) handeln. Sie werden nach üblichen Verfahren in hierfür vorgesehenen Einrichtungen hergestellt.

Bei der Herstellung dieser Homo- oder Copolyamidsäure(ester) und der davon abgeleiteten Homo- oder Copolyimide mit Strukturelementen der Formel I und/oder II geht man zweckmässig so vor, dass man im wesentlichen äquimolare Mengen einer Tetracarbonsäure der Formel XII oder eines ihrer polyamidbildenden Derivate oder Gemischen dieser Verbindungen

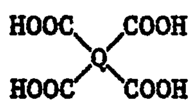

(XII)

mit einem Diamin der Formel XIII oder Gemischen davon oder Gemischen aus wenigstens 5 Mol-%, bezogen auf die Diamine, eines Diamins XIII und höchstens 95 Mol-% eines Diamins XIIIa

$H_2N$-$R^1$-$NH_2$ (XIII),

$H_2N$-$R'^1$-$NH_2$ (XIIIa),

in an sich bekannter Weise polykondensiert und gegebenenfalls anschliessend cyclisiert, oder die gebildete Polyamidsäure ganz oder teilweise mit einem geeigneten Veresterungsmittel umsetzt; dabei besitzen die Reste Q, $R^1$ und $R'^1$ die weiter oben definierte Bedeutung. Anstelle der Tetracarbonsäure(n) XII können auch deren polyamidbildende Derivate verwendet werden, wie z.B. deren Ester, Amide, Halogenide, besonders die Chloride, und Anhydride.

Die Ausgangsverbindungen der Formeln XII und XIIIa sind bekannt und teilweise käuflich erhältlich, während die Diamine der Formel XIII neu sind.

Diese Zwischenprodukte der Formel XIII, insbesondere die alkylsubstituierten Typen, stellen daher ebenfalls einen Gegenstand der vorliegenden Erfindung dar. Besonders bevorzugt werden 1,5- und 1,8-Diamino-9,10-dihydroanthracen.

Die Herstellung dieser Zwischenprodukte erfolgt nach an sich bekannten Verfahren, indem man beispielsweise ein 1,4-, 1,5- oder 1,8-Dinitroanthrachinon, 1,4-, 1,5- oder 1,8-Diaminoanthrachinon oder Gemische dieser Verbindungen zu den entsprechenden Diaminoanthracenderivaten reduziert und anschliessend durch Teilhydrierung die 9,10-Dihydroanthracenderivate herstellt. Die Herstellung der Dinitroanthrachinone ist beispielsweise in der DE-OS 2 439 280 beschrieben. Die Reduktion zu den Diaminoanthracenderivaten erfolgt beispielsweise mit Zn-Staub in alkalischem Medium beispielsweise in einem Methanol-Natronlauge Gemisch. Die Reduktion kann in einigen Fällen direkt bis zur Stufe der Dihydroanthracenderivate geführt werden oder man erhält zunächst die entsprechenden Anthracenderivate, die anschliessend teilhydriert werden. Die Hydrierung erfolgt nach ebenfalls bekannten Methoden, beispielsweise mittels Raney-Nickel oder durch katalytische Hydrierung in Gegenwart von Pd-Kohle oder von $CuO/Cr_2O_3/BaO$ Katalysatoren. Die Herstellung der Zwischenprodukte wird vorteilhaft in inerten Lösungsmitteln durchgeführt. Die Reaktionstemperaturen liegen im allgemeinen je nach Reaktanden im Bereich von 25°C-200°C. Die Kondensation zu den polymeren Endprodukten wird ebenfalls vorteilhafterweise in Lösung durchgeführt; geeignete inerte Lösungsmittel sind nachfolgend genannt. Die Reaktionstemperaturen können hier -20-300°C, vorzugsweise -10-200°C, besonders bevorzugt 0-50°C, betragen.

Als Ausgangsmaterial für die Polykondensation kann die Tetracarbonsäure der Formel XII oder eines ihrer polyamidsäurebildenden Derivate eingesetzt werden.

Die gebildete Polyamidsäure kann dann gegebenenfalls entweder zum entsprechenden Polyimid cyclisiert werden oder man verestert einen Teil oder alle freien Carbonsäuregruppen mit einem geeigneten Veresterungsmittel, beispielsweise mit einem Alkohol oder einem Dialkylsulfat, vorzugsweise mit einem aliphatischen Alkohol, wie Methanol oder Ethanol, oder mit Dimethylsulfat. Bei der Herstellung des Polyamidsäureesters kann man auch vom Dianhydrid der Carbonsäure XII ausgehen, dieses mit zwei Aequivalenten eines Alkohols verestern, die verbleibenden zwei freien Säuregruppen aktivieren, beispielsweise durch Umsetzung mit Thionylchlorid zu den Säurechloriden, und dieses Produkt mit einem Diamin polykondensieren.

Zur Herstellung der Polyimide geht man im einzelnen zweckmässig so vor, dass man Tetracarbonsäuredianhydrid und Diamin zunächst unter Bildung der Polyamidsäurevorstufe in an sich bekannter Weise umsetzt und diese Polyamidsäure anschliessend unter Wasserabspaltung cyclisiert. Die Cyclisierung kann thermisch erfolgen. Vorteilhaft wird die Cyclisierung unter Einwirkung von wasserentziehenden Mitteln, z.B. Carbonsäureanhydriden, wie Acetanhydrid, vorgenommen. Die Polyimide können anschliessend nach üblichen Verfahren, z.B. durch Entfernen des Lösungsmittels oder Ausfällen durch Zugabe eines Nichtlösungsmittels isoliert werden. Die unlöslichen Polyimidtypen dieser Erfindung werden in an sich bekannter Weise in Form des betreffenden Polyamidsäurevorläufers auf das gewünschte Substrat aufgebracht und anschliessend thermisch cyclisiert.

Eine weitere Herstellungsmethode besteht darin, dass man das Tetracarbonsäuredianhydrid mit einem Diisocyanat in einer Stufe zum Polyimid umsetzt.

Dazu setzt man im wesentlichen äquimolare Mengen eines Dianhydrids der Formel XIIa oder von Gemischen solcher Verbindungen

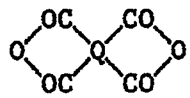 (XIIa),

mit einem Diisocyanat der Formel XIV oder Gemischen davon oder Gemischen aus wenigstens 5 Mol%, bezogen auf die Diisocyanate, eines Diisocyanates XIV und höchstens 95 Mol% eines Diisocyanates XIVa

$OCN-R^1-NCO$ (XIV), $OCN-R'^1-NCO$ (XIVa),

worin Q, $R^1$ und $R'^1$ die weiter oben gegebenen Bedeutungen besitzen in einem inerten Lösungsmittel bei 50 bis 150°C um.

Die Diisocyanate der Formeln XIV und XIVa lassen sich in an sich bekannter Weise aus den entsprechenden Diaminen durch Umsetzung mit Phosgen herstellen. Geeignete inerte Lösungsmittel sind beispielsweise polare, aprotische Lösungsmittel, wie Dimethylsulfoxid oder Dimethylformamid.

Die erfindungsgemässen Polyimide weisen erhöhte Glasübergangstemperaturen auf, die bis über 500°C betragen können. Ueberraschenderweise sind die erfindungsgemässen Polymeren bei erhöhten Temperaturen resistenter gegenüber thermooxidativem Abbau als entsprechende Polymere ohne 9,10-Dihydroanthracenreste. Sie eignen sich somit hervorragend zur Herstellung von Filmen und Schutzüberzügen, insbesondere zur Herstellung von Isolier- und Schutzschichten für leitende, halbleitende oder isolierende Teile und zur Herstellung von wärmebeständigen Folien.

Die erfindungsgemässen Polyimide mit substituierten Diaminresten, die Polyamidsäuren und Polyamidsäureester sind in der Regel in unterschiedlichen Lösungsmitteln löslich, gegebenenfalls unter Erwärmen.

Beschichtungsmittel werden insbesondere in Form von Lösungen der erfindungsgemässen Polymeren, bevorzugt der löslichen Polyimide, in einem Lösungsmittel eingesetzt.

Zur Herstellung des erfindungsgemässen Beschichtungsmittels löst man das Polymer oder Gemische davon zweckmässig in einem geeigneten organischen Lösungsmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Ether, wie Dibutylether, Tetrahydrofuran, Dioxan, Methylenglykol, Dimethylethylenglykol, Dimethyldiethylenglykol, Diethyldiethylenglykol oder Dimethyltriethylenglykol, halogenierte Kohlenwasserstoffe, wie Methylenchlorid, Chloroform, 1,2-Dichlorethan, 1,1,1-Trichlorethan oder 1,1,2,2-Tetrachlorethan, Carbonsäureester und Lactone, wie Essigsäureethylester, Propionsäuremethylester, Benzoesäureethylester, 2-Methoxyethylacetat, γ-Methoxyethylacetat, γ-Butyrolacton, o-Valerolacton und Pivalolacton, Carbonsäureamide und Lactame, wie Formamid, Acetamid, N-Methylformamid, N,N-Dimethylformamid, N,N-Diethylformamid, N,N-Dimethylacetamid, N,N-Diethylacetamid, γ-Butyrolactam, ε-Caprolactam, N-Methylpyrrolidon, N-Acetylpyrrolidon, N-Methylcaprolactam, Tetramethylharnstoff oder Hexamethylphosphorsäureamid, Sulfoxide, wie Dimethylsulfoxid, Sulfone wie Dimethylsulfon, Diethylsulfon, Trimethylsulfon oder Tetramethylsulfon und substituierte Benzole, wie Chlorbenzol, o-Dichlorbenzol, Nitrobenzol, Phenole oder Kresole.

Ungelöste Anteile können durch Filtration, bevorzugt durch Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlauf mittel, feinteilige Füllstoffe, Flammschutzmittel, optische Aufheller, Sensibilisatoren, Antioxidantien, Stabilisatoren, Lichtschutzmittel, Farbstoffe, Pigmente, Haftvermittler und Antihalofarbstoffe, wie sie z.B. in der US-PS 4 349 619 beschrieben sind.

Das Beschichtungsmittel kann mittels üblichen Methoden, wie Tauch-, Streich- und Sprühverfahren, Schleuder-, Kaskadenguss- und Vorhanggussbeschichtung, auf geeignete Substrate bzw. Trägermaterialien aufgebracht werden.

Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$.

Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca. 500 µm und mehr aufweisen.

Es wurde gefunden, dass die erfindungsgemässen Polymeren autophotovernetzbar sind und unter Strahlungseinwirkung vernetzt werden können, wenn sie mindestens 5 Mol-% Strukturelemente der Formel I und/oder II enthalten, worin Q ein Rest einer Arylketontetracarbonsäure ist. Da die Lichtempfindlichkeit mit steigendem Gehalt an solchen Strukturelementen steigt, ist ein Gehalt von mindestens 30 Mol-%, bevorzugt mindestens 50 Mol-% und besonders mindestens 80 Mol-% vorteilhaft.

Schutzfilme aus solchen Polyimiden können durch Strahlungseinwirkung weiter modifiziert werden, womit z.B. noch weiter erhöhte Thermostabilitäten erzielbar sind. Ferner besteht die Möglichkeit, die löslichen Vertreter dieser Polyimide als photographisches Aufzeichnungsmaterial für Reliefabbildungen einzusetzen. Die Polymerschicht des erfindungsgemässen Materials weist eine für viele Anwendungsfälle ausreichende und teilweise hohe Lichtempfindlichkeit auf und sie kann direkt photovernetzt werden. Durch die Direktvernetzung unter Strahlungseinwirkung können Zusätze, wie Sensibilisatoren, vermieden werden und die Schutzschichten, Abbildungen und Filme weisen ausgezeichnete elektrische Eigenschaften auf. Man kann allerdings auch Sensibilisatoren verwenden. Ferner zeichnen sich die Schutzschichten, Abbildungen und Filme durch hohe Haftfestigkeit und thermische, mechanische und chemische Widerstandsfähigkeit aus. Bei thermischen Nachbehandlungen wird nur ein geringer Schwund beobachtet, was in der Anwendung erhebliche Vorteile hat, weil praktische keine Verzerrung abgebildeter Strukturen beobachtet wird bzw. weil keine inneren Spannungen in Ueberzügen und Filmen entstehen.

Das Material ist lagerstabil, aber vorteilhaft vor Lichteinwirkung zu schützen.

Ein weiterer Gegenstand der Erfindung sind Beschichtungsmittel, die in Lösung ein strahlungsempfindliches Polymeres, wie oben definiert, also ein lösliches Polyimid, eine Polyamidsäure oder einen Polyamidsäureester mit den Strukturelementen I und/oder II oder Mischungen solcher Polymerer enthalten.

Ferner zählt zum Gegenstand dieser Erfindung ein mit solchen Polymeren beschichtetes Trägermaterial und die Verwendung dieser Polymeren zur Herstellung von Isolier-, Passivier- und Schutzschichten, von Reliefabbildungen sowie von wärmebeständigen Folien. Die Schichtdicke beträgt für diese Anwendungen bevorzugt 0,5 bis 100 µm, besonders 1 bis 50 µm und insbesondere 1-10 µm.

Die Photostrukturierung bzw. Photovernetzung kann durch energiereiche Strahlung hervorgerufen werden, z.B. durch Licht, insbesondere im UV-Bereich, durch Röntgenstrahlen, Laserlicht, Elektronenstrahlen.

Die Erfindung betrifft auch die durch Strahlung vernetzten Ueberzüge und Folien.

Anwendungsgebiete sind z.B Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten un integrierter Schaltkreise, Relais für die Herstellung von Röntgenmasken, als Lötstopplack, als Dielektrikum für Mehrlagenschaltungen sowie als Strukturelement für Flüssigkristallanzeigen.

Die Herstellung von Schutzfilmen erfolgt in der Regel durch direktes Belichten, wobei sich die Belichtungszeiten im wesentlichen nach den Schichtdicken und der Lichtempfindlichkeit richten und vom Fachmann mittels üblicher Verfahren bestimmt werden können.

Die photographische Erzeugung der Reliefstruktur erfolgt in an sich bekannter Weise durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung sind die gemäss diesen Verfahren erhältlichen Reliefstrukturen. Als Entwickler sind z.B. die zuvor erwähnten Lösungsmittel geeignet.

Die nachfolgenden Beispiele erläutern die Erfindung näher.

Herstellungsbeispiele

Herstellung der Diamine

Beispiel A: 1,5-Diamino-9,10-dihydroanthracen

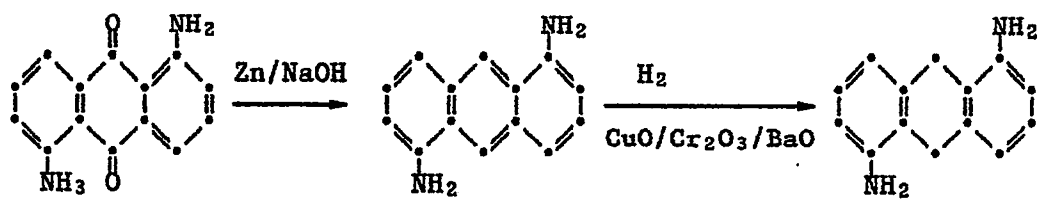


100 g 1,5-Diaminoanthrachinon werden in einer Mischung von 10 l Wasser, 1 l 25-%iger NaOH und 1 l n-Propanol vorgelegt und 100 g Zinkpulver zugegeben. Die Mischung wird auf Rückfluss erhitzt und im Verlaufe von 2,5 Stunden werden 400 g Zinkpulver zugegeben.

Nach 2 weiteren Stunden unter Rückfluss werden 500 ml 25-%ige NaOH und 300 g Zink zugegeben. Nach 20 Stunden unter Rückfluss wird das Reaktionsgemisch abgekühlt, filtriert und der feste Rückstand unter Stickstoff mit Methylenchlorid 24 Stunden lang kontinuierlich extrahiert.
Der Extrakt wird eingedampft und der feste Rückstand getrocknet.

Dieses Zwischenprodukt wird nicht weiter charakterisiert. Es wird in 1,5 l Methanol mit Wasserstoff in Gegenwart eines $CuO/Cr_2O_3/BaO$ Katalysators (Girdeler; G-22-T) bei 100°C und 100 bar bis zum Stillstand der Wasserstoffaufnahme katalytisch hydriert. Das Reaktionsgemisch wird filtriert und der Rückstand mehrmals mit kochendem Ethanol extrahiert. Die gesammelten Extrakte werden zur Trockene eingedampft und der Rückstand aus 2 l Isopropanol umkristallisiert

Es werden 20,5 g 1,5-Diamino-9,10-dihydroanthracen erhalten. Reinheit nach acidimetrischer Titration: 99,48 %
Schmelzpunkt: 179,4°C

Elementaranalyse:

| | C | H | N |
|---|---|---|---|
| berechnet | 79,97 | 6,71 | 13,32 |
| gefunden | 79,84 | 6,77 | 13,20 |
| MS:210. | | | |

Beispiel B: Herstellung von 1,5- und 1,8-Diamino-9,10-dihydroanthracen

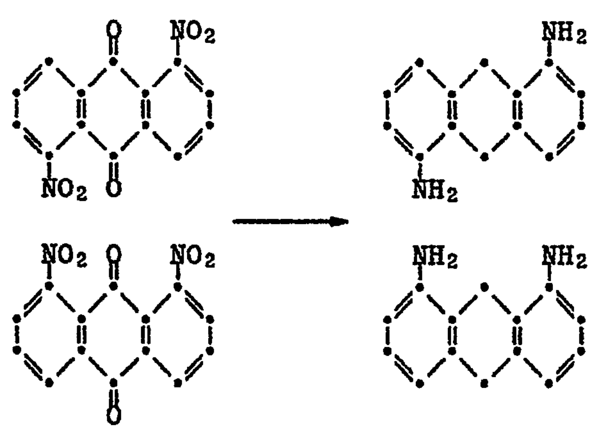

10 g eines Dinitroanthrachinon-Gemisches gemäss Beispiel in Houben-Weyl, Bd. VII/3c, S. 75 (G. Thieme Verlag, 1979) werden gemäss Beispiel 1 mit Zn-Staub reduziert. Der Rückstand der organischen Phase (6,5 g) wird mit 25 ml Chloroform verrührt und filtriert. Kristallisation des Filtergutes (1,2 g) aus 35 ml Isopropylalkohol gibt 0,52 g 1,5-Diamino-9,10-dihydroanthracen, Smp. 178-179°C.

| | | | |
|---|---|---|---|
| Berechnet | C 79,97% | H 6,71% | N 13,32 |
| Gefunden | C 79,70% | H 6,70% | N 13,3%. |

Chromatographie des Rückstandes des Filtrates an 200 g Kieselgel mit $CHCl_3/CH_3OH$ = 9:1 (Volumenteile) als Elutionsmittel gibt weitere 1,1 g 1,5-Diamino-9,10-dihydroanthracen ($R_f$:0,5) und 1,5 g 1,8-Diamino-9,10-dihydroanthracen ($R_f$:0,2).

Beispiel C: Herstellung von 1,8-Diamino-9,10-dihydroanthracen

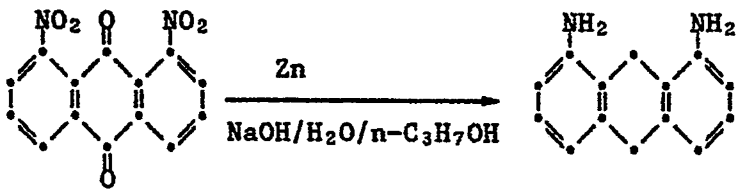


Zu einer Suspension von 48 g (0,161 Mol) 1,8-Dinitroanthrachinon in 1,3 l Wasser, 300 ml n-Propylalkohol und 300 ml 30 %iger NaOH werden in der Siedehitze 210 g Zinkstaub in drei Portionen (2. Portion nach 2 Stunden, 3. Portion nach 3 Stunden) zugesetzt. Das Gemisch wird während 18 Stunden gerührt und unter Rückfluss gekocht. Nach Zugabe von 1 l Chloroform wird filtriert, die organische Phase abgetrennt, mit gesättigter Kochsalzlösung gewaschen, mit $MgSO_4$ getrocknet und eingedampft.
Chromatographie des Rückstandes an 700 g Kieselgel mit Chloroform/Methanol = 9:1 (Volumenteile) als Elutionsmittel gibt 17 g 1,8-Diamino-9,10-dihydroanthracen.
Smp. (Toluol): 138-139°

| | | | |
|---|---|---|---|
| Berechnet | C 79,97% | H 6,71% | N 13,32 |
| Gefunden | C 80,10% | H 7,00% | N 13,1%. |

Herstellung der Polymeren

Beispiel 1

In einem zylindrischen Rührgefäss mit Rührer, Tropftrichter, Innenthermometer, Gaseinleitungsrohr und Gasableitungsrohr werden 0,73 g (0,006 Mol) 2,4-Diaminotoluol und 0,84 g (0,004 Mol) 1,5-Diamino-9,10-dihydroanthracen (Beispiel A) in 39 ml N-Methylpyrrolidon gelöst und unter gleichzeitigem Einleiten von Stickstoff auf 0°C abgekühlt. Zu dieser Lösung werden 3,22 g 3,3',4,4'-Benzophenontetracarbonsäuredianhydrid (0,01 Mol) zugegeben und die Kühlung entfernt.
Nach 5 Stunden wird eine Lösung von 3 ml Triethylamin und 8,5 ml Acetanhydrid eingetropft und die Mischung 18 Stunden lang gerührt. Die Polymerlösung wird auf Wasser gegossen, das Polyimid abfiltriert, mit viel Wasser gewaschen und getrocknet.
Die inhärente Viskosität, gemessen als 0,5 prozentige Lösung in NMP, beträgt 0,72 dl/g.
Die Glasumwandlungstemperatur (DSC) beträgt 334°C.

Beispiele 2-6:

Gemäss Beispiel 1 werden verschiedene Diamine mit 3,3',4,4'-Benzophenontetracarbonsäuredianhydrid zu (Co)polyimiden umgesetzt. Die Ergebnisse findet man in folgender Tabelle.

| Beispiel | Diamin | η inh. | Tg (°C) (DSC) |
|---|---|---|---|
| 2 | Diamin aus Beispiel A (50 Mol %)<br>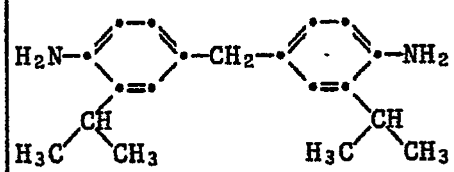 (50 Mol %) | 1,06 | 305 |
| 3 | Diamin aus Beispiel A (50 Mol %)<br>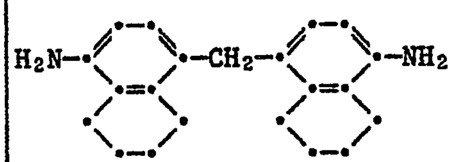 (50 Mol %) | 1,04 | 349 |
| 4 | Diamin aus Beispiel A (50 Mol %)<br>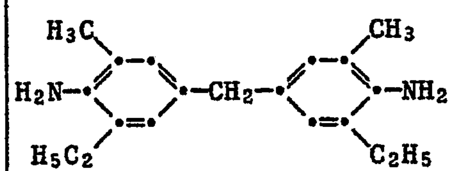 (50 Mol %) | 0,80 | 322 |
| 5 | Diamin aus Beispiel A (50 Mol %)<br>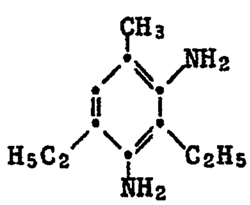 (50 Mol %) | 0,60 | 376 |
| 6 | Diamin aus Beispiel A (100 Mol %) | -- | *) |

*) Bis zu einer Temperatur von 655°C lässt sich im DSC-Experiment keine Glasumwandlung erkennen.

Beispiele 7 und 8: (Polyamidsäure und Polyamidsäureester)

Gemäss Beispiel 1 werden 3,22 g (0,01 Mol) 3,3',4,4'-Benzophenontetracarbonsäuredianhydrid mit 2,115 g (0,01 Mol) 1,5-Diamino-9,10-dihydroanthracen in NMP zur Polyamidsäure umgesetzt. Die Polyamidsäure wird in Abweichung von Beispiel 1 nicht mit Acetanhydrid und Triäthylamin zum Polyimid cyclisiert sondern ein Teil der Polyamidsäure (Beispiel 7) wird direkt für die Belichtungsversuche aus dem Gefäss entnommen, der Rest (Beispiel 8) wird mit 3,4 g (0,022 Mol) Diethylsulfat und 3 g (0,022 Mol) Kaliumcarbonat zum entsprechenden Polyamidsäureethylester verestert.'

Beispiel 9:

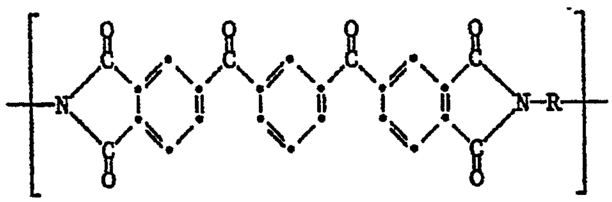

R = 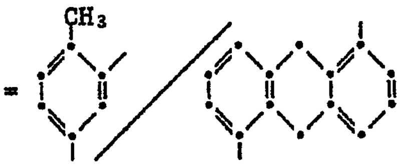

In einem zylindrischen Rührgefäss mit Rührer, Tropftrichter, Innenthermometer, Gaseinleitungsrohr und Gasableitungsrohr werden 0,7327 g (0,006 Mol) 2,4-Diaminotoluol und 0,8411 g (0,004 Mol) 1,5-Diamino-9,10-dihydroanthracen in 39 ml N-Methylpyrrolidon gelöst und unter gleichzeitigem Einleiten von Stickstoff auf 0°C abgekühlt. Zu dieser Lösung werden 4,2533 g (0,010 Mol) 4,4'-Isophthaloyl-bis-phthalsäureanhydrid zugegeben und die Kühlung entfernt.
Nach 5 Stunden wird eine Lösung von 3 ml Triethylamin und 8,5 ml Acetanhydrid eingetropft und die Mischung 18 Stunden lang gerührt. Die Polymerlösung wird auf Wasser gegossen, das Polyimid abfiltriert, mit Wasser nachgewaschen und im Vakuum getrocknet.
Ausbeute: 5,28 g
Inhärente Viskosität: 0,244 dl/g (gemessen bei 25°C in einer 0,5%igen Lösung in NMP).

Beispiel 10:

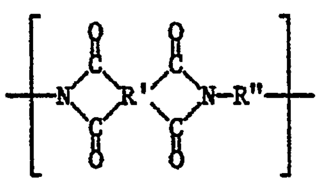

R' = 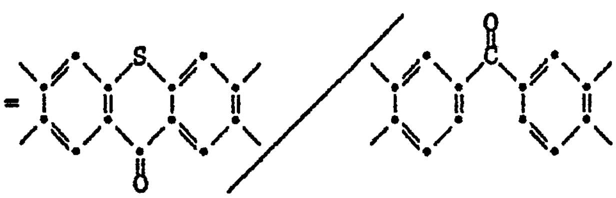

R" = 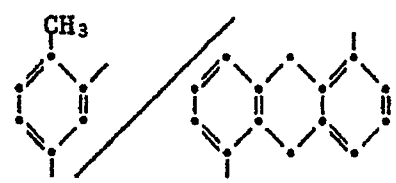

Im einem zylindrischen Rührgefäss mit Rührer, Tropftrichter, Innenthermometer, Gaseinleitungsrohr und Gasableitungsrohr werden 0,7326 g (0,006 Mol) 2,4-Diaminotoluol und 0,8411 g (0,004 Mol) 1,5-Diamino-9,10-dihydroanthracen in 39 ml N-Methylpyrrolidon gelöst und unter gleichzeitigem Einleiten von Stickstoff auf 0°C abgekühlt. Zu dieser Lösung werden 0,7045 g (0,002 Mol) Thioxanthontetracarbonsäuredianhydrid zugegeben und die Kühlung entfernt. Nach 2 Stunden bei Raumtemperatur werden 2,5778 g (0,008 Mol) Benzophenontetracarbonsäuredianhydrid zugegeben. Nach 5 Stunden wird eine Lösung von 3 ml Triethylamin und 8,5 ml Acetanhydrid eingetropft und die Mischung 18 Stunden lang gerührt. Die Polymerlösung wird auf Wasser gegossen, das Polyimid abfiltriert, mit Wasser nachgewaschen, filtriert und im Vakuum getrocknet.
Ausbeute: 4,5 g
Inhärente Viskosität: 0,61 dl/g (gemessen bei 25°C in einer 0,5%igen Lösung in NMP).

Anwendungsbeispiele

I. Herstellung von Reliefbildern

Auf einer einseitig kupfer-kaschierten Kunststoffplatte wird ein dünner (ca. 1-2 µm) Polymerfilm erzeugt, indem eine 5 %ige Polymerlösung aufgeschleudert wird und das Lösungsmittel anschliessend in einem Umluftofen entfernt wird. Als Lösungsmittel wird N-Methylpyrrolidon verwendet.

Die so beschichteten Platten werden durch eine Photomaske (Stouffer-Keil) bei Raumtemperatur mit einer 1000 Watt-UV-Lampe aus 18 cm Entfernung belichtet. Die belichteten Platten werden anschliessend mit einem Lösungsmittel entwickelt, wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung. Die Resultate findet man in der folgenden Tabelle.

| Polymer gemäss Beispiel | Belichtungszeit (sec.) | Empfindlichkeit (Stouffer Skala) |
|---|---|---|
| 1 | 30 | 5 |
| 2 | 30 | 6 |
| 3 | 20 | 4 |
| 4 | 5 | 5 |
| 5 | 30 | 5 |
| 6 | 60 | 8 |
| 7 | 60 | 8 |

II. Thermooxydative Stabilität

Gemessen wird der Gewichtsverlust der eintritt, wenn das Material 60 Min. lang in Luft bei 400°C isotherm gehalten wird.
Polymer aus Beispiel 1: 1,9 Gew.%
Polymer aus Beispiel 5: 9,9 Gew.%
Polymer aus Beispiel 6: 1,0 Gew.%
Polymer aus Beispiel 9: 2,3 Gew.%
Polymer aus Beispiel 10: 1,0 Gew.%

III. Nachweis der Lichtempfindlichkeit ausgewählter Polymerer

Man arbeitet wie unter Beispiel I beschrieben und belichtet einen Polymerfilm durch eine Photomaske (Stouffer-Keil). Nach der Entwicklung mit N-Methylpyrrolidon sind die unbelichteten Anteile des Polymerfilms weggelöst. Die Ergebnisse findet man in der folgenden Tabelle.

| Polymer gemäss Beispiel | Belichtungszeit (min.) | Empfindlichkeit (Stouffer Skala) |
|---|---|---|
| 9 | 5 | 2 |
| 10 | 3 | 4 |

**Patentansprüche für alle Vertragsstaaten mit Ausnahme von ES**

1. Homo- oder Copolyamidsäure(ester) und davon abgeleitete Homo- oder Copolyimide enthaltend mindestens 5 Mol % Struktureinheiten der Formel I und/oder II

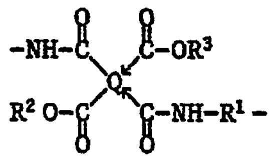 (I), 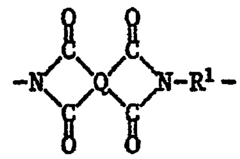 (II),

worin Q ein unsubstituierter oder substituierter vierwertiger aromatischer Rest ist, an den je zwei Carbonylgruppen in ortho- oder peri-Position gebunden sind, $R^1$ ausgewählt wird aus den Resten der Formeln III, IV oder V

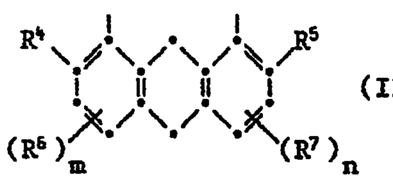 (III), 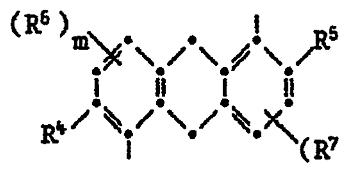 (IV),

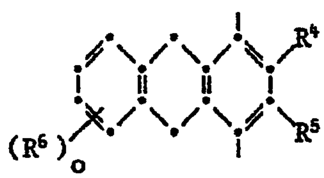 (V),

$R^2$, $R^3$, $R^4$ und $R^5$ unabhängig voneinander Wasserstoff, Alkyl, Cycloalkyl, gegebenenfalls substituiertes Aryl oder Aralkyl bedeuten,
$R^6$ und $R^7$ unabhängig voneinander Aryl oder Halogen darstellen,
m und n unabhängig voneinander 0, 1 oder 2 sind,
o 0, 1, 2, 3 oder 4 bedeutet, wobei die Reste $R^1$ bis $R^7$ innerhalb der gegebenen Definitionen unterschiedliche Bedeutungen annehmen können und die Pfeile in Formel I für Stellungsisomerie stehen.

2. Verbindungen gemäss Anspruch 1, worin der Rest Q ausgewählt wird aus den Strukturen

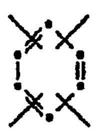 , 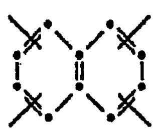 , 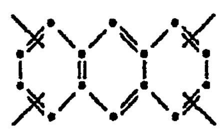 ,

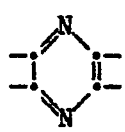 , 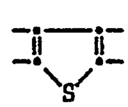 , 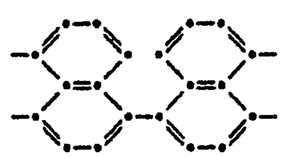 ,

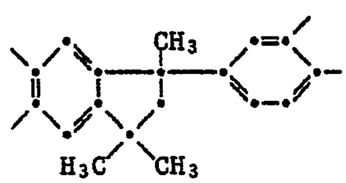 , 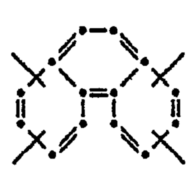 und

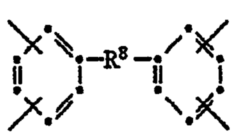 ,

worin $R^8$ eine direkte Bindung oder eine Brückengruppe der Formeln -O-, -S-, $-SO_2$, $-CH_2$, $-C(CH_3)_2$- oder -CO- ist.

3. Verbindungen gemäss Anspruch 1, worin Q sich von Benzophenontetracarbonsäure ableitet.

4. Verbindungen gemäss Anspruch 1, worin der Rest Q ausgewählt wird aus der Gruppe bestehend aus

a) den Strukturen der Formel VI

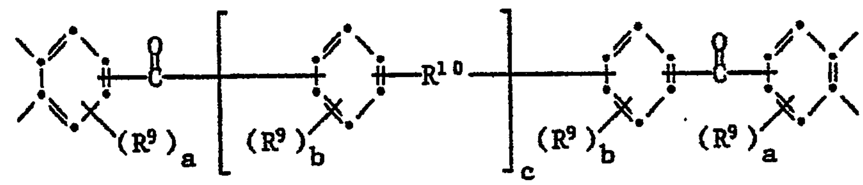
(VI),

worin $R^9$ für $C_1$-$C_6$-Alkyl, $C_1$-$C_6$-Alkoxy, $C_1$-$C_6$-Alkylthio, Phenyl, Phenyloxy oder Phenylthio steht,
$R^{10}$ eine direkte Bindung oder ein Brückengruppe der Formeln -O-, -S-, $-SO_2$-, $-CH_2$-, $-C(CH_3)_2$- oder -CO- bedeutet,
a für 0, 1, 2 oder 3, b für 0,1, 2, 3 oder 4 und c für 0, 1, 2, 3, 4 oder 5 steht, und, wenn a und b 2 sind, beide $R^9$ zusätzlich zu den oben gegebenen Definitionen auch in o-Stellung zueinander gebunden sind und zusammen -CH=CH-CH=CH- bedeuten, und

b) den Strukturen der Formeln VIII, IX, X und XI

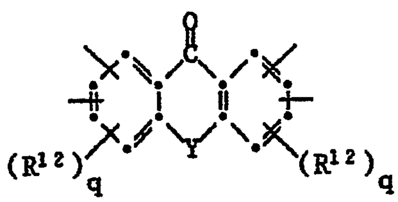
(VIII),
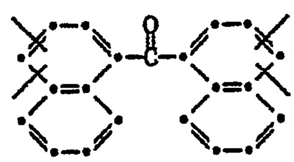
(IX),
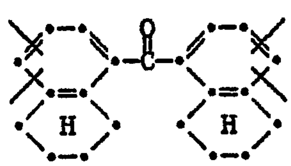
(X),
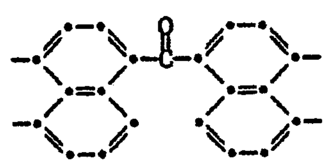
(XI),

in denen die freien Bindungen in Orthostellung zueinander stehen und Y eine direkte Bindung, $-CH_2$-, $-(CH_2)_2$, -O-, -S-, $-SO_2$-, -CO-, $-NR^{11}$- oder $-CR^{13}R^{14}$- bedeutet, wobei $R^{11}$ und $R^{13}$ ein Wasserstoffatom, $C_1$-$C_6$-Alkyl oder Phenyl sind, ist und $R^{14}$ die Bedeutung von $R^{13}$ mit Ausnahme der Bedeutung eines Wasserstoffatomes hat, $R^{12}$ für $C_1$-$C_6$-Alkyl, $C_1$-$C_6$-Alkoxy oder Phenoxy steht und $q = 0$, 1 oder 2 ist.

5. Verbindungen gemäss Anspruch 4, worin Q ausgewählt wird aus der Gruppe bestehend aus

a) den Resten der Formel VIa oder VIb

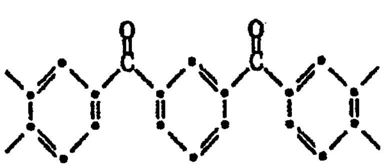
(VIa),
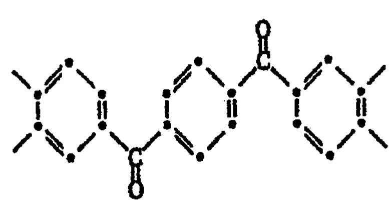
(VIb

und

b) den Resten der Formeln VIIIa, VIIIb, VIIIc oder VIIId

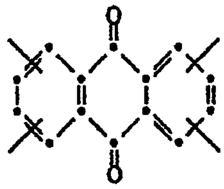 (VIIIa), 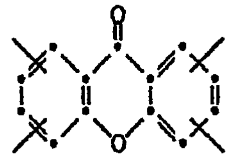 (VIIIb),

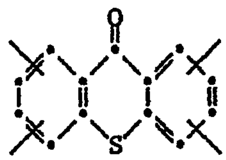 (VIIIc), 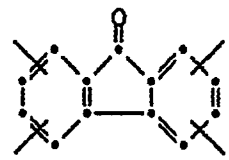 (VIIId).

6. Homo- oder Copolyimide enthaltend mindestens 30 Mol%, bezogen auf das Gesamtpolymere, an Struktureinheiten der Formel II gemäss Anspruch 1, worin die Reste $R^1$ unsubstituiert sind oder höchstens zwei $C_1$-$C_6$-Alkylsubstituenten tragen.

7. Homo- oder Copolyimide bestehend aus wiederkehrenden Struktureinheiten der Formel II gemäss Anspruch 1.

8. Verbindungen gemäss Anspruch 6, enthaltend ausschliesslich aromatische Diaminreste, die sich ableiten von unsubstituierten oder höchstens zweifach $C_1$-$C_6$-alkylsubstituierten Resten der Formeln III, IV oder V und gegebenenfalls weiteren unsubstituierten oder höchstens vierfach $C_1$-$C_6$-alkylsubstituierten aromatischen Diaminresten, wobei der Anteil der alkylsubstituierten Diaminreste mindestens so gross gewählt wird, dass die Polymeren sich in aprotischen organischen Lösungsmitteln lösen.

9. Verbindungen gemäss Anspruch 8, worin Q ein vierwertiger diarylketonhaltiger Rest ist.

10. Copolyamidsäure(ester) enthaltend 30-100 Mol%, bezogen auf das Gesamtpolymere, an Strukturelementen der Formel I gemäss Anspruch 1, worin $R^2$ und $R^3$ unabhängig voneinander Wasserstoff oder Alkyl sind.

11. Verbindungen der Formel XIII
$H_2N$-$R^1$-$NH_2$ (XIII),
worin $R^1$ ein Rest der Formeln III, IV oder V gemäss Anspruch 1 ist.

12. Beschichtungsmittel enthaltend in Lösung ein strahlungsempfindliches Polymeres gemäss Anspruch 1 oder eine Mischung solcher Polymerer.

13. Ein mit strahlungsempfindlichen Polymeren gemäss Anspruch 1 oder mit einer Mischung solcher Polymerer beschichtetes Trägermaterial.

14. Verwendung der Polymeren gemäss Anspruch 1 zur Herstellung von Isolier-, Passivier- und Schutzschichten, von Reliefabbildungen sowie von wärmebeständigen Folien.

15. Die durch Strahlungsvernetzung von Polymeren gemäss Anspruch 1 erhältlichen Ueberzüge und Folien.

16. Die durch bildmässige Belichtung von Polymeren gemäss Anspruch 1 erhältlichen Reliefstrukturen.

**Patentansprüche für denVertragsstaat: ES**

1. Verfahren zur Herstellung von Homo- oder Copolyamidsäure(ester)n und davon abgeleiteten Homo-oder Copolyimiden enthaltend mindestens 5 Mol % Struktureinheiten der Formel I und/oder II

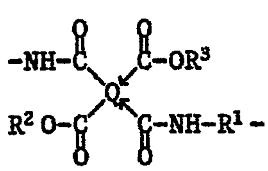 (I), 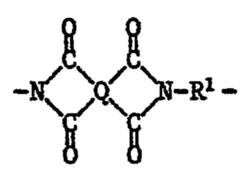 (II),

worin Q ein unsubstituierter oder substituierter vierwertiger aromatischer Rest ist, an den je zwei Carbonylgruppen in ortho- oder peri-Position gebunden sind, $R^1$ ausgewählt wird aus den Resten der Formeln III, IV oder V

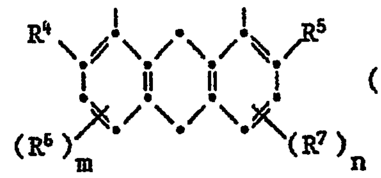 (III), 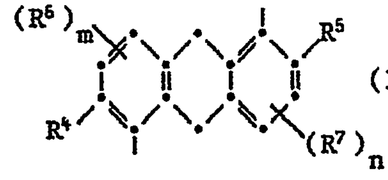 (IV),

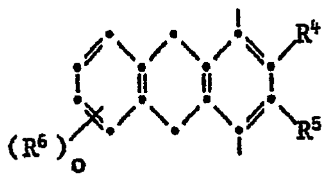 (V),

$R^2$, $R^3$, $R^4$ und $R^5$ unabhängig voneinander Wasserstoff, Alkyl, Cycloalkyl, gegebenenfalls substituiertes Aryl oder Aralkyl bedeuten,
$R^6$ und $R^7$ unabhängig voneinander Aryl oder Halogen darstellen,
m und n unabhängig voneinander 0, 1 oder 2 sind,
o 0, 1, 2, 3 oder 4 bedeutet, wobei die Reste $R^1$ bis $R^7$ innerhalb der gegebenen Definitionen unterschiedliche Bedeutungen annehmen können und die Pfeile in Formel I für Stellungsisomerie stehen, umfassend die Schritte

i) Polykondensation von im wesentlichen äquimolaren Mengen einer Tetracarbonsäure der Formel XII oder eines ihrer polyamidbildenden Derivate oder Gemischen dieser Verbindungen

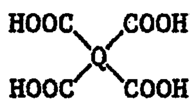 (XII),

mit einem Diamin der Formel XIII oder Gemischen davon oder Gemischen aus wenigstens 5 Mol-%, bezogen auf die Diamine, eines Diamins XIII und höchstens 95 Mol-% eines Diamins XIIIa
$H_2N-R^1-NH_2$ (XIII), $H_2N-R'^1-NH_2$ (XIIIa),
worin Q und $R^1$ die weiter oben gegebene Bedeutung besitzen und $R'^1$ ein zweiwertiger unsubstituierter oder substituierter aliphatischer, gegebenenfalls durch Heteroatome, aromatische, heterocyclische oder cycloaliphatische Gruppen unterbrochener Rest ist oder eine unsubstituierte oder substituierte cycloaliphatische, aromatische, heterocyclische oder araliphatische Gruppe ist, und

ii) gegebenenfalls Cyclisierung oder vollständige oder teilweise Veresterung der gebildeten Polyamidsäure.

2. Verfahren gemäss Anspruch 1, worin der Rest Q ausgewählt wird aus den Strukturen

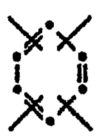 , 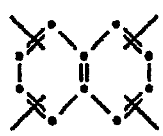 , 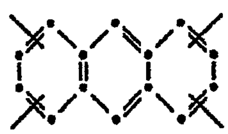 ,

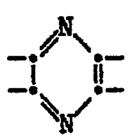 , 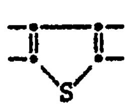 , 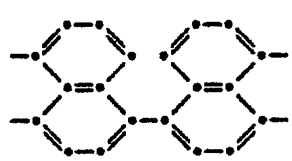 ,

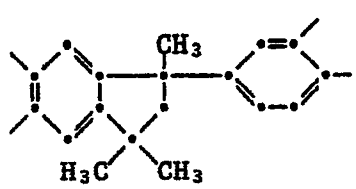 , 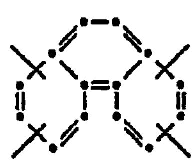 und

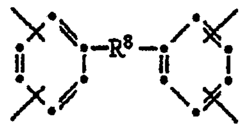,

worin $R^8$ eine direkte Bindung oder eine Brückengruppe der Formeln -O-, -S-, $-SO_2-$, $-CH_2$, $-C(CH_3)_2-$ oder -CO- ist.

3. Verfahren gemäss Anspruch 1, worin Q sich von Benzophenontetracarbonsäure ableitet.

4. Verfahren gemäss Anspruch 1, worin der Rest Q ausgewählt wird aus der Gruppe bestehend aus

a) den Strukturen der Formel VI

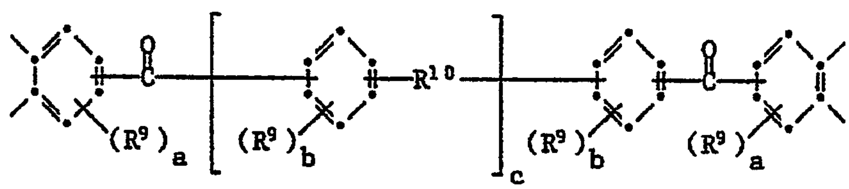 (VI),

worin $R^9$ für $C_1$-$C_6$-Alkyl, $C_1$-$C_6$-Alkoxy, $C_1$-$C_6$-Alkylthio, Phenyl, Phenyloxy oder Phenylthio steht,

$R^{10}$ eine direkte Bindung oder ein Brückengruppe der Formeln -O-, -S-, $-SO_2-$, $-CH_2-$, $-C(CH_3)_2-$ oder -CO- bedeutet,

a für 0, 1, 2 oder 3, b für 0,1, 2, 3 oder 4 und c für 0, 1, 2, 3, 4 oder 5 steht, und, wenn a und b 2 sind, beide $R^9$ zusätzlich zu den oben gegebenen Definitionen auch in o-Stellung zueinander gebunden sind und zusammen -CH=CH-CH=CH- bedeuten, und

b) den Strukturen der Formeln VIII, IX, X und XI

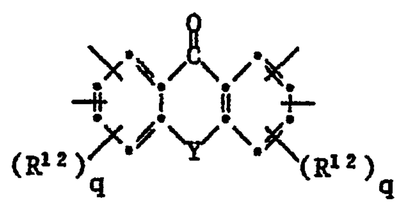 (VIII), 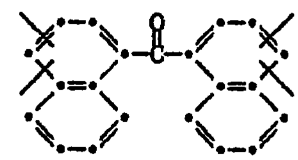 (IX),

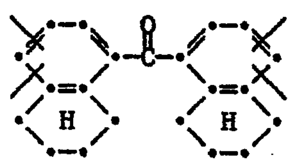 (X), 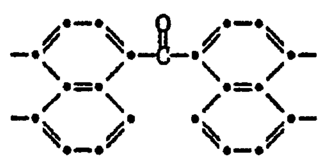 (XI),

in denen die freien Bindungen in Orthostellung zueinander stehen und Y eine direkte Bindung, $-CH_2-$, $-(CH_2)_2-$, -O-, -S-, $-SO_2-$, -CO-, $-NR^{11}-$ oder $-CR^{13}R^{14}-$ bedeutet, wobei $R^{11}$ und $R^{13}$ ein Wasserstoffatom, $C_1$-$C_6$-Alkyl oder Phenyl sind, ist und $R^{14}$ die Bedeutung von $R^{13}$ mit Ausnahme der Bedeutung eines Wasserstoffatomes hat, $R^{12}$ für $C_1$-$C_6$-Alkyl, $C_1$-$C_6$-Alkoxy oder Phenoxy steht und q = 0, 1 oder 2 ist.

5. Verfahren gemäss Anspruch 4, worin Q ausgewählt wird aus der Gruppe bestehend aus

a) den Resten der Formel VIa oder VIb

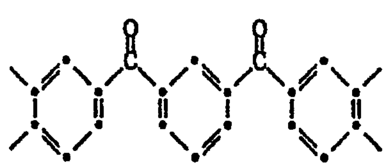 (VIa), 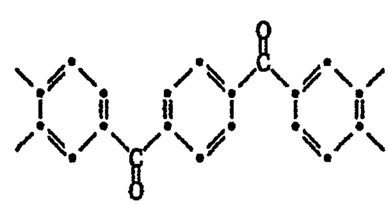 (VIb)

und

b) den Resten der Formeln VIIIa, VIIIb, VIIIc oder VIIId

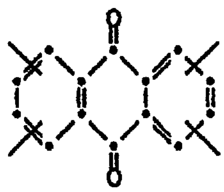 (VIIIa),

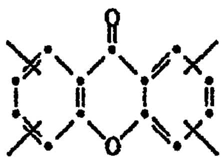 (VIIIb),

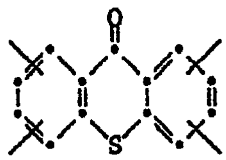 (VIIIc),

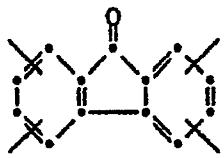 (VIIId).

6. Verfahren zur Herstellung von Homo- und Copolyimiden gemäss Anspruch 1, worin mindestens 30 Mol%, bezogen auf die Gesamtmenge, eines im wesentlichen äquimolaren Gemisches aus Tetracarbonsäure der Formel XII oder eines polyamidbildenden Derivates davon oder eines Gemisches dieser Verbindungen und aus Diamin der Formel XIII oder Gemischen davon eingesetzt werden und worin die Reste $R^1$ unsubstituiert sind oder höchstens zwei $C_1$-$C_6$-Alkylsubstituenten tragen.

7. Verfahren zur Herstellung von Homo- und Copolyimiden gemäss Anspruch 1, worin im wesentlichen äquimolare Gemische aus Tetracarbonsäure der Formel XII oder einem ihrer polyamidbildenden Derivate oder einem Gemisch dieser Verbindungen mit dem Diamin der Formel XIII oder Gemischen davon polykondensiert werden und anschliessend cyclisiert werden.

8. Verfahren gemäss Anspruch 6, worin ausschliesslich aromatische Diaminreste, die sich ableiten von unsubstituierten oder höchstens zweifach $C_1$-$C_6$-alkylsubstituierten Resten der Formeln III, IV oder V gemäss Beispiel 1 und gegebenenfalls weitere unsubstituierte oder höchstens vierfach $C_1$-$C_6$-alkylsubstituierte aromatische Diaminreste verwendet werden, wobei der Anteil der alkylsubstituierten Diaminreste mindestens so gross gewählt wird, dass die Polymeren sich in aprotischen organischen Lösungsmitteln lösen.

9. Verfahren gemäss Anspruch 8, worin Q ein vierwertiger diarylketonhaltiger Rest ist.

10. Verfahren zur Herstellung von Copolyamidsäure(ester)n gemäss Anspruch 1, worin mindestens 30 Mol-%, bezogen auf die Gesamtmenge, eines im wesentlichen äquimolaren Gemisches aus Tetracarbonsäure der Formel XII oder eines polyamidbildenden Derivates davon oder eines Gemisches dieser Verbindungen und aus Diamin der Formel XIII oder Gemischen davon eingesetzt werden und die gebildete Polyamidsäure gegebenenfalls vollständig oder teilsweise mit einem zur Einführung von Alkylgruppen befähigten Reagenz verestert wird.

11. Verfahren zur Herstellung von Homo- oder Copolyimiden enthaltend mindestens 5 Mol% Struktureinheiten der Formel II

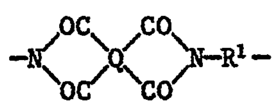 (II),

gekennzeichnet durch Umsetzung von im wesentlichen äquimolaren Mengen eines Dianhydrids der Formel XIIa oder von Gemischen solcher Verbindungen

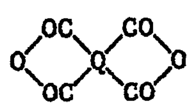 (XIIa),

mit einem Diisocyanat der Formel XIV oder von Gemischen solcher Verbindungen oder von Gemischen aus wenigstens 5 Mol%, bezogen auf die Diisocyanate, eine Diisocyanates XIV und höchstens 95 Mol% eines Diisocyanates XIVa

OCN-$R^1$-NCO (XIV), OCN-$R'^1$-NCO (XIVa),

in einem inerten Lösungsmittel bei 50 bis 150°C; dabei besitzen die Reste Q, $R^1$ und $R'^1$ die in Anspruch 1 angegebene Bedeutung.

12. Verfahren zur Herstellung von Verbindungen der Formel XIII
$H_2N-R^1-NH_2$ (XIII),
worin $R^1$ die in Anspruch 1 definierten Bedeutungen besitzt, umfassend die Schritte
i) Reduktion von 1,4-, 1,5- oder 1,8-Dinitroanthrachinon oder von 1,4-, 1,5 oder 1,8-Diaminoanthrachinon oder von Gemischen dieser Verbindungen zu den entsprechenden Diaminoanthracenderivaten oder den entsprechenden 9,10-Dihydroanthracenverbindungen und gegebenenfalls
ii) Teilhydrierung der Diaminoanthracenderivate zu den 9,10-Dihydroanthracenverbindungen.

13. Beschichtungsmittel enthaltend in Lösung ein strahlungsempfindliches Polymeres erhältlich gemäss Anspruch 1 oder eine Mischung solcher Polymerer.

14. Ein mit strahlungsempfindlichen Polymeren erhältlich gemäss Anspruch 1 oder mit einer Mischung solcher Polymerer beschichtetes Trägermaterial.

15. Verwendung der Polymeren erhältlich gemäss Anspruch 1 zur Herstellung von Isolier-, Passivier- und Schutzschichten, von Reliefabbildungen sowie von wärmebeständigen Folien.

16. Verfahren zur Herstellung von Ueberzügen und Folien, dadurch gekennzeichnet, dass man Ueberzüge und Folien aus Polymeren erhältlich gemäss Anspruch 1 durch energiereiche Strahlung vernetzt.

17. Verfahren zur Herstellung von Reliefstrukturen, dadurch gekennzeichnet, dass man Ueberzüge aus Polymeren erhältlich gemäss Anspruch 1 durch energiereiche Strahlung bildmässig belichtet.

**Claims for the Contracting States: BE CH DE FR GB IT LI NL SE**

1. A homo- or copolyamide acid (ester) or homo- or copolyimide derived therefrom containing at least 5 mol% of structural units of the formula I and/or II

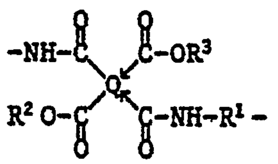 (I), 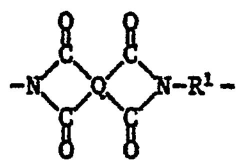 (II),

in which Q is an unsubstituted or substituted tetravalent aromatic radical to which in each case two carbonyl groups are bonded in the ortho- or peri-position, $R^1$ is selected from the radicals of the formulae III, IV and V

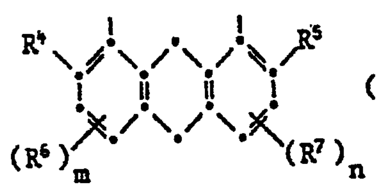 (III), 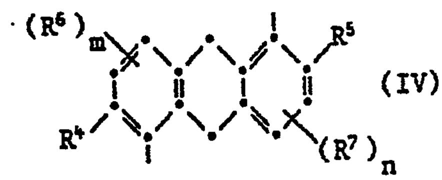 (IV),

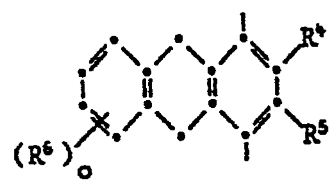 (V),

$R^2$, $R^3$, $R^4$ and $R^5$ independently of one another are hydrogen, alkyl, cycloalkyl or substituted or unsubstituted aryl or aralkyl, $R^6$ and $R^7$ independently of one another are aryl or halogen, m and n independently of one another are 0, 1 or 2 and o is 0, 1, 2, 3 or 4, it being possible for the radicals $R^1$ to $R^7$ to assume different meanings within the definitions given, and the arrows in formula I represent position isomerism.

2. A compound according to claim 1, in which the radical Q is selected from the structures

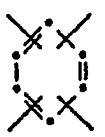 , 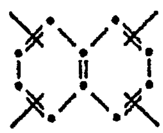 , 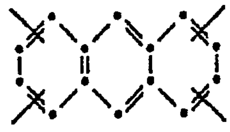 ,

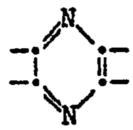 , 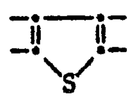 , 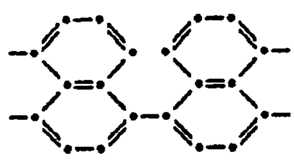 ,

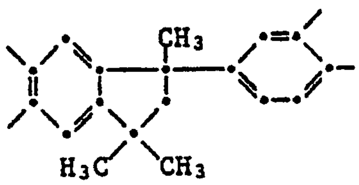 , 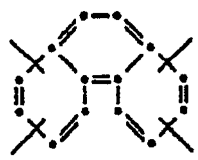 and

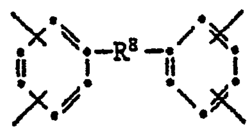 ,

in which $R^8$ is a direct bond or a bridge group of the formulae $-O-$, $-S-$, $-SO_2-$, $-CH_2$, $-C(CH_3)_2-$ or $-CO-$.

3. A compound according to claim 1, in which Q is derived from benzophenonetetracarboxylic acid.

4. A compound according to claim 1, in which the radical Q is selected from the group comprising

a) the structures of the formula VI

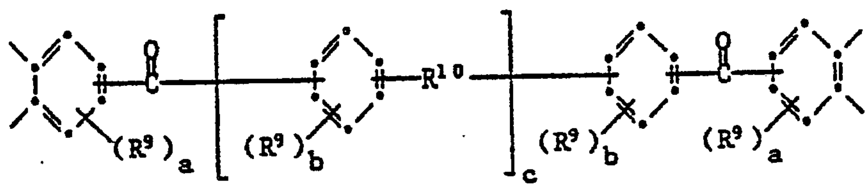 (VI),

in which $R^9$ is $C_1$–$C_6$alkyl, $C_1$–$C_6$alkoxy, $C_1$–$C_6$alkylthio, phenyl, phenyloxy or phenylthio, $R^{10}$ is a direct bond or a bridge group of the formulae $-O-$, $-S-$, $-SO_2-$, $-CH_2-$, $-C(CH_3)_2-$ or $-CO-$, a is 0, 1, 2 or 3, b is 0, 1, 2, 3 or 4 and c is 0, 1, 2, 3, 4 or 5, and, if a and b are 2, the two symbols $R^9$, in addition to being as defined above, are also bonded to one another in the o-position and together are $-CH=CH-CH=CH-$, and

b) the structures of the formulae VIII, IX, X and XI

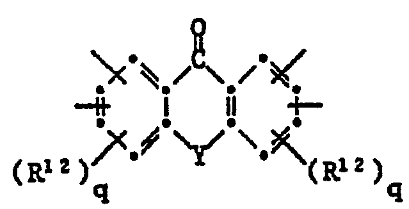 (VIII), 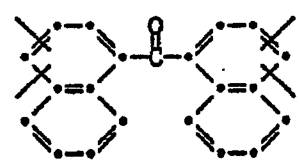 (IX),

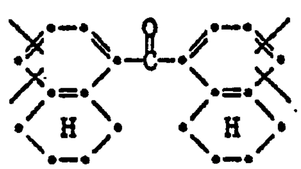 (X), 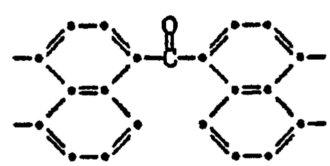 (XI),

in which the free bonds are in the ortho-position relative to one another and Y is direct

bond, $-CH_2-$, $-(CH_2)_2-$, $-O-$, $-S-$, $-SO_2-$, $-CO-$, $-NR^{11}-$ or $-CR^{13}R^{14}-$, in which $R^{11}$ and $R^{13}$ are hydrogen atoms, $C_1$–$C_6$alkyl or phenyl and $R^{14}$ has the meaning of $R^{13}$, with the exception of a hydrogen atom, $R^{12}$ is $C_1$–$C_6$alkyl, $C_1$–$C_6$alkoxy or phenoxy and 1 is 0, 1 or 2.

5. A compound according to claim 4, in which Q is selected from the group comprising

a) the radicals of the formulae VIa and VIb

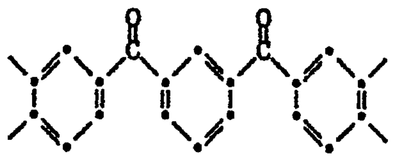 (VIa), 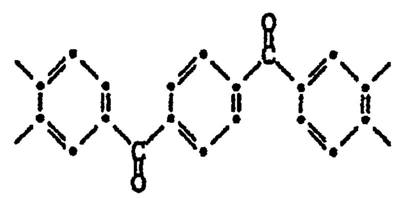 (VIt

and

b) the radicals of the formulae VIIIa, VIIIb, VIIIc or VIIId

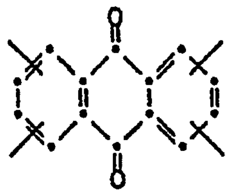 (VIIIa), 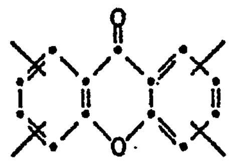 (VIIIb),

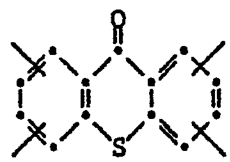 (VIIIc), 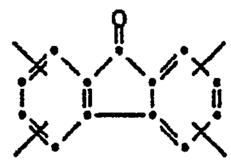 (VIIId).

6. A homo- or copolyimide containing at least 30 mol%, based on the total polymer, of structural units of the formula II according to claim 1, in which the radicals $R^1$ are unsubstituted or carry not more than two $C_1$–$C_6$alkyl substituents.

7. A homo- or copolyimide consisting of recurring structural units of the formula II according to claim 1.

8. A compound according to claim 6, containing exclusively aromatic diamine radicals which are derived from unsubstituted or not more than di-$C_1$–$C_6$alkyl-substituted radicals of the formulae III, IV or V and if appropriate other unsubstituted or not more than tetra-$C_1$–$C_6$alkyl-substituted aromatic diamine radicals, the content of alkyl-substituted diamine radicals being at least high enough for the polymers to dissolve in aprotic organic solvents.

9. A compound according to claim 8, in which Q is a tetravalent radical containing diaryl ketone.

10. A copolyamide acid (ester) containing 30–100 mol%, basel on the total polymer, of structural elements of the formula I according to claim 1, in which $R^2$ and $R^3$ independently of one another are hydrogen or alkyl.

11. A compound of the formula XIII

$$H_2N-R^1-NH_2 \qquad (XIII)$$

in which $R^1$ is a radical of the formulae III, IV or V according to claim 1.

12. A coating agent containing, in solution, a polymer according to claim 1 which is sensitive to radiation or a mixture of such polymers.

13. A carrier material coated with a polymer according to claim 1 which is sensitive to radiation or with a mixture of such polymers.

14. A method of using a polymer according to claim 1 for the production of insulating, passivating and protective coatings, relief images and heat-stable films.

15. A coating film obtaining by crosslinking of a polymer according to claim 1 by radiation.

16. A relief structure obtainable by image-wise exposure of a polymer according to claim 1.

**Claims for the Contracting State: ES**

1. A process for the preparation of a homo- or copolyamide acid (ester) or homo- or copolyimide derived therefrom containing at least 5 mol% of structural units of the formula I and/or II

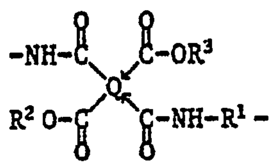 (I), 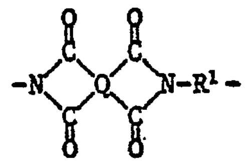 (II),

in which Q is an unsubstituted or substituted tetravalent aromatic radical to which in each case two carbonyl groups are bonded in the ortho- or peri-position, $R^1$ is selected from the radicals of the formulae III, IV and V

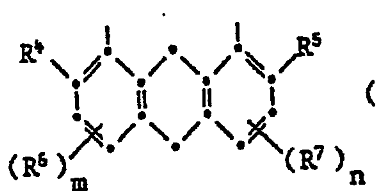 (III), 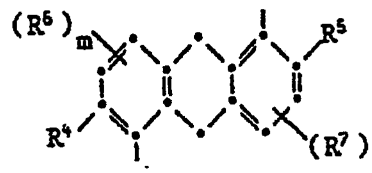 (IV),

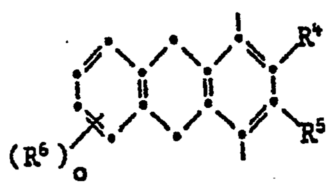 (V),

$R^2$, $R^3$, $R^4$ and $R^5$ independently of one another are hydrogen, alkyl, cycloalkyl or substituted or unsubstituted aryl or aralkyl, $R^6$ and $R^7$ independently of one another are aryl or halogen, m and n independently of one another are 0, 1 or 2 and o is 0, 1, 2, 3 or 4, it being possible for the radicals $R^1$ to $R^7$ to assume different meanings within the definitions given, and the arrows in formula I represent position isomerism, comprising the steps

i) subjecting essentially equimolar amounts of a tetracarboxylic acid of the formula XII or one of its derivatives which form a polyamide or mixtures of these compounds

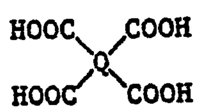 (XII)

to a polycondensation reaction with a diamine of the formula XIII or mixtures thereof or mixtures of at least 5 mol%, based on the diamines, of a diamine XIII and not more than 95 mol% of a diamine XIIIa

$H_2N-R^1-NH_2$ (XIII)

$H_2N-R'^1-NH_2$ (XIIIa)

in which Q and $R^1$ are as defined above and $R'^1$ is a divalent unsubstituted or substituted aliphatic radical which may be interrupted by hetero atoms or aromatic, heterocyclic or cyloaliphatic groups, or is an unsubstituted or substituted cycloaliphatic, aromatic, heterocyclic or araliphatic group and

ii) if appropriate cyclizing the product, or completely or partly esterifying the resulting polyamide acid.

2. A process according to claim 1, in which the radical Q is selected from the structures

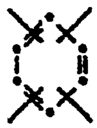 , 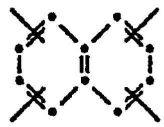 , 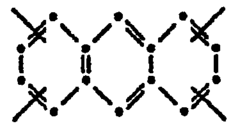 ,

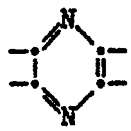 , 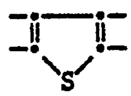 , 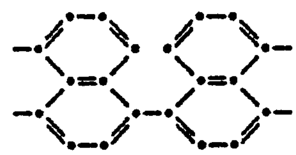 ,

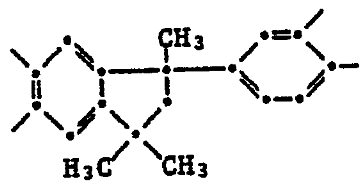 , 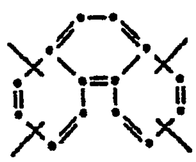 and

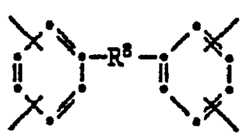 ,

in which $R^8$ is a direct bond or a bridge group of the formulae –O–, –S–, $–SO_2–$, $–CH_2$, $–C(CH_3)_2–$ or –CO–.

3. A process according to claim 1, in which Q is derived from benzophenonetetracarboxylic acid.

4. A process according to claim 1, in which the radical Q is selected from the group comprising

a) the structures of the formula VI

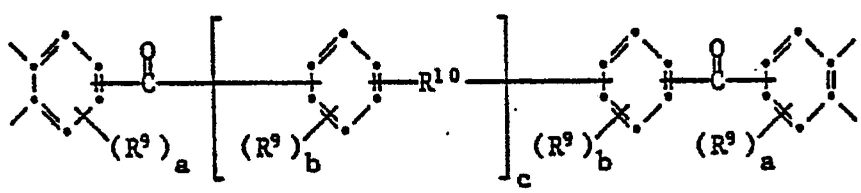 (VI),

in which $R^9$ is $C_1$–$C_6$alkyl, $C_1$–$C_6$alkoxy, $C_1$–$C_6$alkylthio, phenyl, phenyloxy or phenylthio, $R^{10}$ is a direct bond or a bridge group ot the formulae –O–, –S–, $–SO_2–$, $–CH_2$, $–C(CH_3)_2–$ or –CO–, a is 0, 1, 2 or 3, b is 0, 1, 2, 3 or 4 and c is 0, 1, 2, 3, 4 or 5, and, if a and b are 2, the two symbols $R^9$, in addition to being as defined above, are also bonded to one another in the o-position and together are –CH=CH–CH=CH–, and

b) the structures of the formulae VIII, IX, X and XI

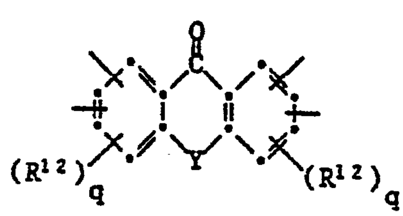 (VIII), 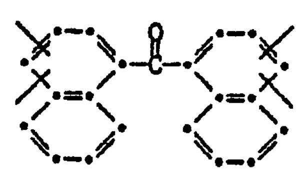 (IX),

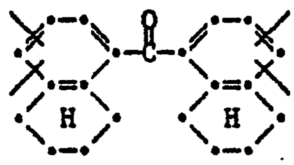 (X), 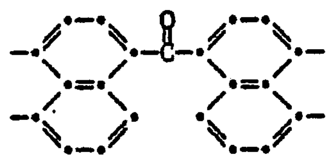 (XI),

in which the free bonds are in the ortho-position relative to one another and Y is a direct bond, $-CH_2-$, $-(CH_2)_2-$, $-O-$, $-S-$, $-SO_2-$, $-CO-$, $-NR^{11}-$ or $-CR^{13}R^{14}-$, in which $R^{11}$ and $R^{13}$ are hydrogen atoms, $C_1$–$C_6$alkyl or phenyl and $R^{14}$ has the meaning of $R^{13}$ with the exception of a hydrogen atom, $R^{12}$ is $C_1$–$C_6$alkyl, $C_1$–$C_6$alkoxy or phenoxy and q is 0, 1 or 2.

5. A process according to claim 4, in which Q is selected from the group comprising

a) the radicals of the formula VIa or VIb

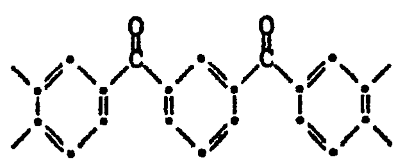 (VIa), 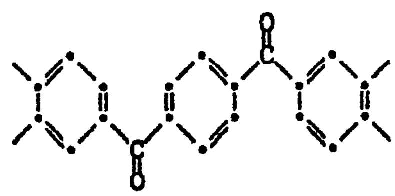 (VIb

and

b) the radicals of the formulae VIIIa, VIIIb, VIIIc or VIIId

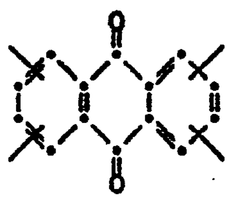 (VIIIa), 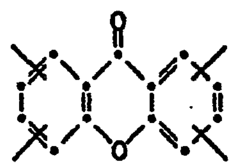 (VIIIb),

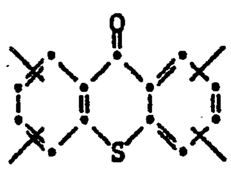 (VIIIc), 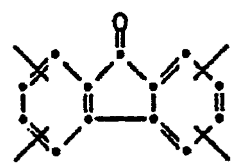 (VIIId).

6. A process for the preparation of a homo- or copolyimide according to claim 1, in which at least 30 mol%, based on the total amount, of an essentially equimolar mixture of tetracarboxylio acid of the formula XII or of a derivative thereof which forms a polyamide or of a mixture of these compounds and of diamine of the formula XIII or a mixture thereof are employed, in which the radicals $R^1$ are unsubstituted or carry not more than two $C_1$–$C_6$alkyl substituents.

7. A process for the preparation of a homo- or copolyimide according to claim 1, in which an essentially equimolar mixture of tetracarboxylic acid of the formula XII or one of its derivatives which form a polyamide or of a mixture of these compounds are subjected to a polycondensation reaction with the diamine of the formula XIII or a mixture thereof, and the product is subsequently cyclized.

8. A process according to claim 6, in which exclusively aromatic diamine radicals which are derived from unsubstituted or not more than di-$C_1$–$C_6$alkyl-substituted radicals of the formula III, IV or V according to Example 1 and if appropriate other unsubstituted or not more than tetra-$C_1$–$C_6$alkyl-substituted aromatic diamine radicals are used, the content of alkyl-substituted diamine radicals being at least high enough for the polymers to dissolve in aprotic organic solvents.

9. A process according to claim 8, in which Q is a tetravalent radical containing diaryl ketone.

10. A process for the preparation of a copolyamide acid (ester) according to claim 1, in which at least 30 mol%, based on the total amount, of an essentially equimolar mixture of tetracarboxylic acid of the formula XII or of a derivative thereof which forms a polyamide or of a mixture of these compounds and of diamine of the formula XIII or a mixture thereof are employed, and the resultant polyamide acid may be completely or partly esterified by means of a reagent which is capable of introducing alkyl groups.

11. A process for the preparation of a homo- or copolyamide containing at least 5 mol% of structural units of the formula II

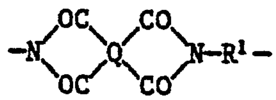 (II)

which comprises reacting an essentially equimolar amount of a dianhydride of the formula XIIa or of a mixture of such compounds

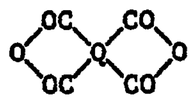 (XIIa)

with a diisocyanate of the formula XIV or of a mixture of such compounds or of a mixture of at least 5 mol%, based on the diisocyanates, a diisocyanate XIV and not more than 95 mol% of a diisocyanate XIVa

$OCN-R^1-NCO$ (XIV), $OCN-R'^1-NCO$ (XIVa),

in an inert solvent at 50 to 150°C; the radicals Q, $R^1$ and $R'^1$ being as defined in claim 1.

12. A process for the preparation of a compound of the formula XIII

$H_2N-R^1-NH_2$ (XIII)

in which $R^1$ is as defined in claim 1, comprising the steps

i) reducing a 1,4-, 1,5- or 1,8-dinitroanthraquinone or 1,4-, 1,5- or 1,8-diaminoanthraquinone or a mixture of these compounds to the corresponding diaminoanthracene derivative or the corresponding 9,10-dihydroanthracene compound and if appropriate

ii) partially hydrogenating the diaminoanthracene derivative to the 9,10-dihydroanthracene compound.

13. A coating agent containing, in solution, a polymer obtainable according to claim 1 which is sensitive to radiation or a mixture of such polymers.

14. A carrier material coated with a polymer obtainable according to claim 1 which is sensitive to radiation or with a mixture of such polymers.

15. Use of a polymer obtainable according to claim 1 for the production of insulating, passivating and protective coatings, relief images and heat-stable films.

16. A method for the production of a coating or film which comprises crosslinking a coating or film of a polymer obtainable according to claim 1 by high-energy radiation.

17. A method for the production of a relief structure, which comprises exposing a coating of a polymer obtainable according to claim 1 image-wise by high-energy radiation.

**Revendications pour les Etats contractants: BE, CH, DE, FR, GB, IT, LI, NL, SE**

1. Homo- ou co-polyamide-acides (esters) et homo- ou co-polyimides dérivant de ces polyamides-acides qui contiennent au moins 5% en moles d'unités structurales répondant aux formules I et/ou II:

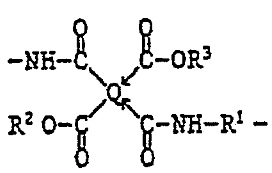 (I), 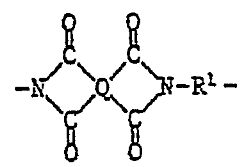 (II)

dans lesquelles:

Q représente un radical aromatique quadrivalent, substitué ou non, auquel les deux éléments de chacun des couples de radicaux carbonyles sont liés en position ortho ou péri,

$R^1$ est choisi dans l'ensemble constitué par les radicaux répondant aux formules III, IV et V:

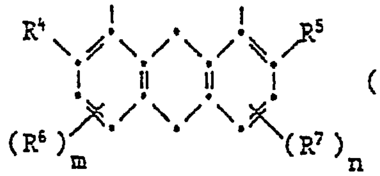 (III),

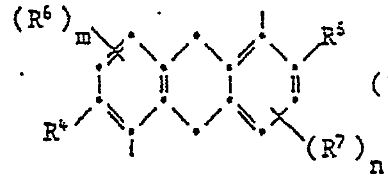 (IV),

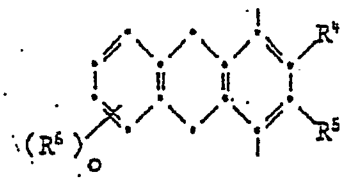 (V),

$R^2$, $R^3$, $R^4$ et $R^5$ représentent chacun, indépendamment les uns des autres, l'hydrogène, un alkyle, un cycloalkyle, ou un radical aryle ou aralkyle éventuellement substitué,
$R^6$ et $R^7$ représentent chacun, indépendamment l'un de l'autre, un aryle ou un halogène,
m et n représentent chacun, indépendamment l'un de l'autre, un nombre égal à 0, 1 ou à 2 et
o représente un nombre égal à 0, à 1, à 2, à 3 ou à 4, les symboles $R^1$ et $R^7$ pouvant prendre des significations différentes dans le cadre des définitions qui viennent d'être données, et les flèches, dans la formule I, indiquant une isomérie de position.

2. Composés selon la revendication 1 dans lesquels Q représente un radical pris dans l'ensemble constitué par les radicaux de formules:

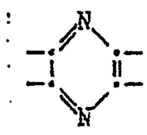 , 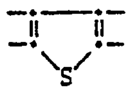 , 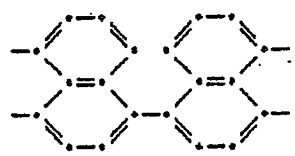 ,

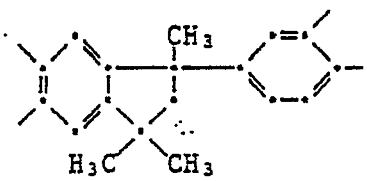 , 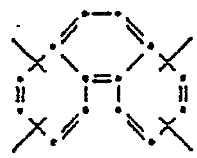 et

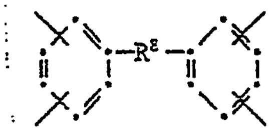 ,

où $R^8$ représente une liaison directe ou un radical formant pont de formule –O–, –S–, $-SO_2-$, $-CH_2-$, $C(CH_3)_2-$ ou –CO–.

3. Composés selon la revendication 1 dans lesquels Q dérive d'un acide benzophénone-tétracarboxylique.

4. Composés selon la revendication 1 dans lesquels Q représente un radical pris dans l'ensemble constitué par:

a) les radicaux répondant à la formule VI:

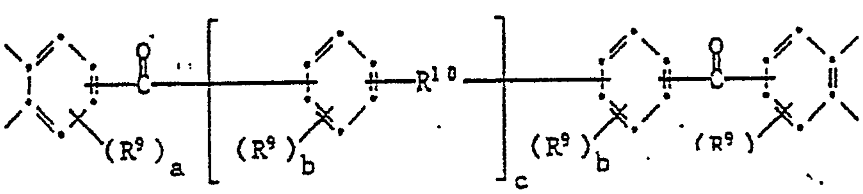 (VI)

dans laquelle $R^9$ représente un alkyle en $C_1$–$C_6$, un alcoxy en $C_1$–$C_6$, un alkylthio en $C_1$–$C_6$, un phény-

le, un phényloxy ou un phénylthio, $R^{10}$ représente une liaison directe ou un radical formant pont de formule $-O-$, $-S-$, $-SO_2-$, $-CH_2-$, $C(CH_3)_2-$ ou $-CO-$, a est égal à 0, à 1, à 2 ou à 3, b est égal à 0, à 1, à 2, à 3 ou à 4 et c est égal à 0, à 1, à 2, à 3 à 4 ou à 5, et, lorsque a et b sont égaux chacun à 2, les deux $R^9$ peuvent non seulement avoir les significations qui ont été données ci-dessus mais encore être en position ortho l'un par rapport à l'autre et former ensemble un radical $-CH=CH-CH=CH-$, et
b) les radicaux répondant aux formules VIII, IX, X et XI:

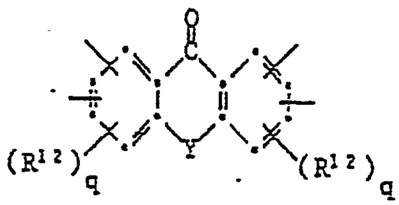 (VIII), 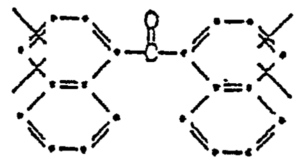 (IX),

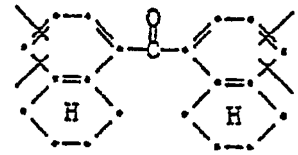 (X), 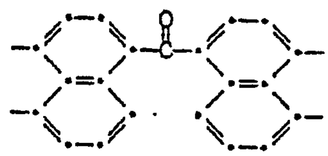 (XI).

dans lesquelles les liaisons libres sont en position ortho l'une par rapport à l'autre, Y représente une liaison directe, $-CH_2-$, $-(CH_2)_2)-$, $-O-$, $-S-$, $-SO_2$, $-CO-$, $-NR^{11}-$ ou $-CR^{13}R^{14}-$, les symboles $R^{11}$ et $R^{13}$ représentant chacun un atome d'hydrogène, un alkyle en $C_1$–$C_6$ ou un phényle, et
$R^{14}$ ayant la signification de $R^{13}$ sans toutefois pouvoir représenter un atome d'hydrogène, $R^{12}$ représente un alkyle en $C_1$–$C_6$, un alcoxy en $C_1$–$C_6$ ou un phénoxy, et q est égal à 0, à 1 ou à 2.

5. Composés selon la revendication 4 dans lesquels Q représente un radical pris dans l'ensemble constitué par:
a) les radicaux répondant aux formules VIa et VIb:

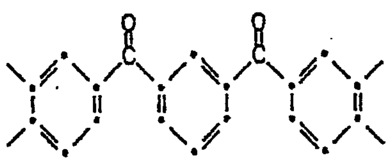 (VIa), 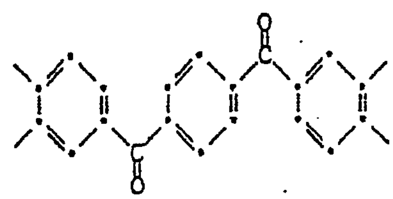 (VIb)

b) les radicaux répondant aux formules VIIIa et VIIIb, VIIIc et VIIId:

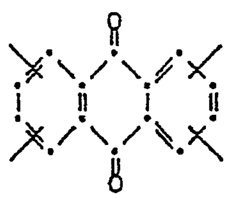 (VIIIa), 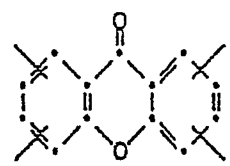 (VIIIb),

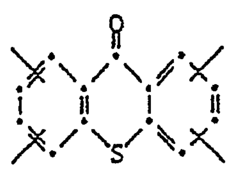 (VIIIc), 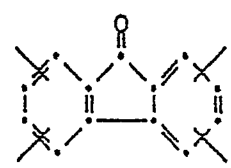 (VIIId).

6. Homo- ou co-polyamide-acides qui contiennent au moins 30% en moles, par rapport au polymère total, d'unités structurales de formules II selon la revendication 1 dans lesquelles les radicaux $R^1$ sont dépourvus de substituants ou portent au plus deux radicaux alkyles en $C_1$–$C_6$.

7. Homo- ou co-polyamide-acides constitués d'unités structurales répétées de formule II selon la revendication 1.

8. Composés selon la revendication 6 qui contiennent exclusivement des radicaux de diamines aromatiques qui dérivent de radicaux de formule III, IV ou V non substitués ou porteurs d'au plus deux alkyles en $C_1$–$C_6$ et, éventuellement, d'autres radicaux de diamines aromatiques non substitués ou porteurs d'au plus 4 alkyles en $C_1$–$C_6$, la proportion des radicaux de diamines alkylés étant au moins suffisamment élevée pour que les polymères se dissolvent dans des solvants organiques aprotiques.

9. Composés selon la revendication 8 dans lesquels Q représente un radical quadrivalent contenant une diaryl-cétone.

10. Copolyamide-acides (esters) contenant de 30 à 100% en moles, par rapport au polymère total, d'unités structurales de formule I selon la revendication 1 dans lesquelles $R^2$ et $R^3$ représentent chacun, indépendamment l'un de l'autre, l'hydrogène ou un radical alkyle.

11. Composés répondant à la formule XVIII:

$$H_2N-R^1-NH_2 \qquad (XIII)$$

dans laquelle $R^1$ représente un radical de formule III, IV ou V selon la revendication 1.

12. Produits de revêtement contenant, en solution, un polymère photosensible selon la revendication 1 ou un mélange de polymères de ce genre.

13. Matière support revêtu d'un polymère photosensible selon la revendication 1 ou d'un mélange de polymères de ce genre.

14. Application des polymères selon la revendication 1 à la production de couches isolantes, passivantes et protectrices, d'images en relief ainsi que de feuilles stables à la chaleur.

15. Revêtements et feuilles qui peuvent être obtenus par photoréticulation de polymères selon la revendication 1.

16. Structures en relief qui peuvent être obtenues par exposition de polymères selon la revendication 1 à une irradiation conformément à une image.

**Revendications pour l'Etat contractant: ES**

1. Procédé pour préparer des homo- ou co-polyamide-acides (esters) et homo- ou co-polyimides dérivant de ces polyamides-acides qui contiennent au moins 5% en moles d'unités structurales répondant aux formules I et/ou II:

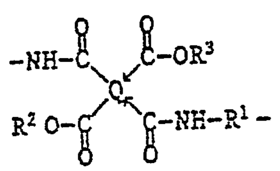
(I),
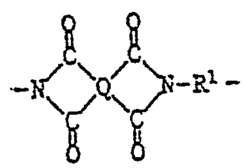
(II)

dans lesquelles:

Q représente un radical aromatique quadrivalent, substitué ou non, auquel les deux éléments de chacun des couples de radicaux carbonyles sont liés en position ortho ou péri,

$R^1$ est choisi dans l'ensemble constitué par les radicaux répondant aux formules III, IV et V:

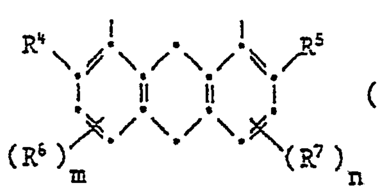
(III),
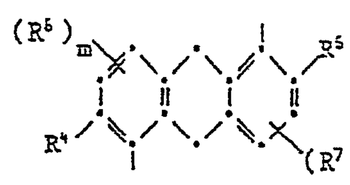
(IV),
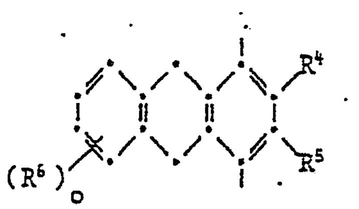
(V),

$R^2$, $R^3$, $R^4$ et $R^5$ représentent chacun, indépendamment les uns des autres, l'hydrogène, un alkyle, un cycloalkyle, ou un radical aryle ou aralkyle éventuellement substitué,
$R^6$ et $R^7$ représentent chacun, indépendamment l'un de l'autre, un aryle ou un halogène, m et n représentent chacun, indépendamment l'un de l'autre, un nombre égal à 0, 1 ou à 2 et
o représente un nombre égal à 0, à 1, à 2, à 3 ou à 4, les symboles $R^1$ et $R^7$ pouvant prendre des significations différentes dans le cadre des définitions qui viennent d'être données, et les flèches, dans la formule I, indiquant une isomérie de position, procédé qui comprend les étapes suivantes:

i) polycondensation de quantités sensiblement équimolaires d'un acide tétracarboxylique de formule XII:

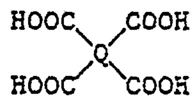 (XII),

ou d'un de ses dérivés générateurs de polyamides, ou d'un mélange de composés de ce genre, et d'une diamie de formule XIII, ou d'un mélange de telles diamines, ou d'un mélange constitué d'au moins 5% en moles, par rapport aux diamines, d'une diamine de formule XIII et d'au plus 95% en moles d'une diamine de formule XIIIa:

$$H_2N-R^1-NH_2 \quad (XIII) \qquad H_2N-R'^1-NH_2 \quad (XIIIa),$$

formules dans lesquelles Q et $R^1$ ont les significations qui leur ont été données ci-dessus et $R'^1$ représente un radical aliphatique bivalent, substitué ou non, éventuellement interrompu par des hétéroatomes ou par des radicaux aromatiques, hétérocyclique ou cycloaliphatiques, ou représente un radical cycloaliphatique, aromatique, hétérocyclique ou araliphatique, substitué ou non,

ii) éventuellement cyclisation ou estérification totale ou partielle du polyamide-acide formé.

2. Procédé selon la revendication 1 dans lequel le symbole Q représente un radical pris dans l'ensemble constitué par les radicaux répondant aux formules suivantes:

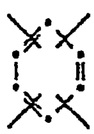 , 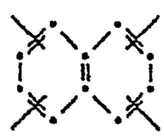 , 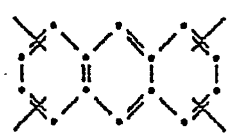 ,

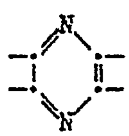 , 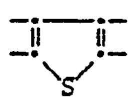 , 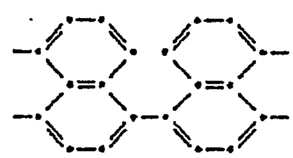 ,

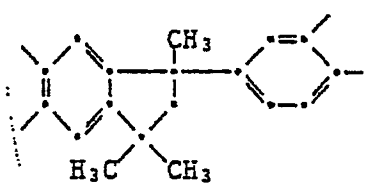 , 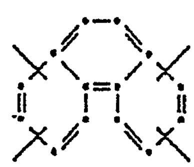 et

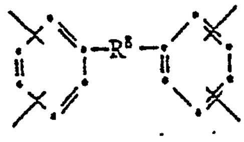 ,

où $R^8$ représente une liaison directe ou un radical formant pont pris dans l'ensemble constitué par $-O-$, $-S-$, $-SO_2-$, $-CH_2-$, $C(CH_3)_2-$ et $-CO-$.

3. Procédé selon la revendication 1 dans lequel Q dérive d'un acide benzophénone-tétracarboxylique.

4. Procédé selon la revendication 1 dans lequel le symbole Q est pris dans l'ensemble constitué par:

a) les radicaux répondant à la formule VI:

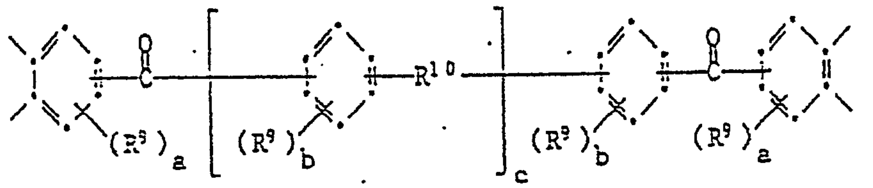 (VI)

dans laquelle $R^9$ représente un alkyle en $C_1$–$C_6$, un alcoxy en $C_1$–$C_6$, un alkylthio en $C_1$–$C_6$, un phényle, un phényloxy ou un phénylthio, $R^{10}$ représente une liaison directe ou un radical formant pont de formule –O–, –S–, $-SO_2-$, $-CH_2-$, $C(CH_3)_2-$ ou –CO–, a est égal à 0, à 1, à 2 ou à 3, b est égal à 0, à 1, à 2, à 3 ou à 4 et c est égal à 0, à 1, à 2, à 3 à 4 ou à 5, et, lorsque a et b sont égaux chacun à 2, les deux $R^9$ peuvent non seulement avoir les significations qui ont été données ci-dessus mais encore être en position ortho l'un par rapport à l'autre et former ensemble un radical –CH=CH–CH=CH–, et

b) les radicaux répondant aux formules VIII, IX, X et XI:

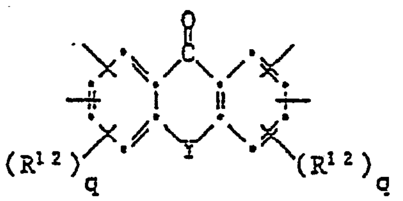 (VIII), 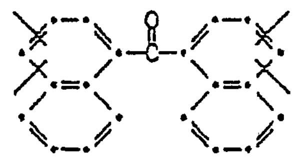 (IX),

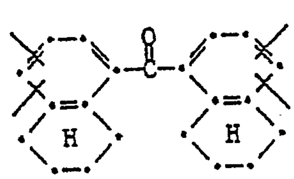 (X), 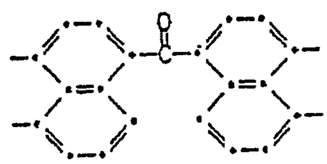 (XI),

dans lesquelles les liaisons libres sont en position ortho l'une par rapport à l'autre, Y représente une liaison directe, $-CH_2-$, $-(CH_2)_2)-$, –O–, –S–, $-SO_2$, –CO–, $-NR^{11}-$ ou $-CR^{13}R^{14}-$, les symboles $R^{11}$ et $R^{13}$ représentant chacun un atome d'hydrogène, un alkyle en $C_1$–$C_6$ ou un phényle, et $R^{14}$ ayant la signification de $R^{13}$ sans toutefois pouvoir représenter un atome d'hydrogène, $R^{12}$ représente un alkyle en $C_1$–$C_6$, un alcoxy en $C_1$–$C_6$ ou un phénoxy, et q est égal à 0, à 1 ou à 2.

5. Procédé selon la revendication 4 dans lequel le symbole Q représente un radical pris dans l'ensemble constitué par:

a) les radicaux de formules VIa et VIb:

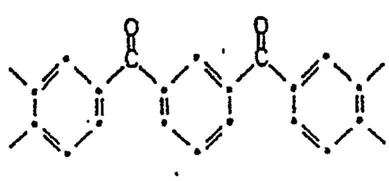 (VIa), 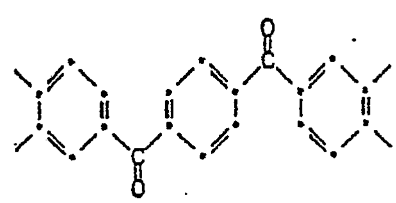 (VIb)

et

b) les radicaux de formules VIIIa et VIIIb, VIIIc et VIIId:

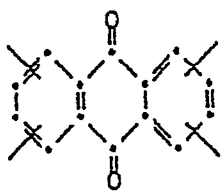 (VIIIa), 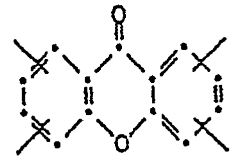 (VIIIb),

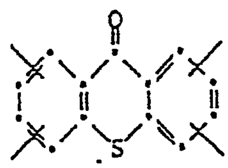 (VIIIc), 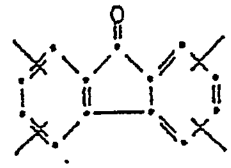 (VIIId).

6. Procédé pour préparer des homo- ou co-polyimides selon la revendication 1, procédé selon lequel on utilise au moins 30% en moles, par rapport à la quantité totale, d'un mélange sensiblement équimolaire d'un acide tétracarboxylique de formule XII, ou d'un dérivé d'un tel acide capable d'engendrer des polyamides, ou d'un mélange de composés de ce genre, et d'un diamine de formule XIII, ou d'un mélange de diamines de ce genre, et selon lequel les radicaux $R^1$ ne portent pas de substituants ou portent au plus deux radicaux alkyles en $C_1$–$C_6$.

7. Procédé pour préparer des homo- ou co-polyimides selon la revendication 1, procédé selon lequel on polycondense un mélange sensiblement équimolaire d'un acide tétracarboxylique de formule XII, ou d'un de ses dérivés générateurs de polyamides, ou d'un mélange de composés de ce genre, avec une diamine de formule XII, ou un mélange de diamines de ce genre, puis on cyclise.

8. Procédé selon la revendication 6, procédé selon lequel on utilise exclusivement des radicaux de diamines aromatiques qui dérivent de radicaux de formule III, IV ou V selon la revendication 1, non substitués ou porteurs d'au plus deux alkyles an $C_1$–$C_6$ et, éventuellement, d'autres radicaux de diamines aromatiques non substitués ou porteurs d'au plus 4 alkyles en $C_1$–$C_6$, la proportion des radicaux de diamines alkylés étant au moins suffisamment grande pour que les polymères se dissolvent dans des solvants organiques aprotiques.

9. Procédé selon la revendication 8 dans lequel le symbole Q représente un radical quadrivalent contenant une diaryl-cétone.

10. Procédé de préparation de co-polyamide-acides (esters) selon la revendication 1, procédé selon lequel on utilise au moins 30% en moles, par rapport à la quantité totale, d'un mélange sensiblement équimolaire d'un acide tétracarboxylique de formule XII, ou d'un dérivé d'un tel acide capable d'engendrer des polyamides, ou d'un melange de composés de ce genre, et d'une diamine de formule XIII, ou d'un mélange de diamines de ce genre, et on estérifie éventuellement le polyamide-acide formé, totalement ou partiellement, au moyen d'un réactif capable d'introduire des radicaux alkyles.

11. Procédé pour préparer des homo- ou copolyimides contenant au moins 5% en moles d'unités structurales de formule II:

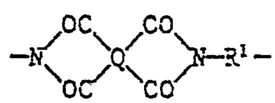 (II),

procédé caractérisé en ce qu'on fait réagir des quantités sensiblement équimolaires d'un dianhydride de formule XIIa:

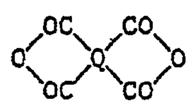 (XIIa),

ou d'un mélange de dianhydrides de ce genre, et d'un diisocyanate de formule XIV, ou d'un mélange de diisocyanates de ce genre, ou d'un mélange d'au moins 5% en moles, par rapport aux diisocyanates, d'un di-isocyanate de formule XIV et d'au plus 95% en moles d'un diisocyanate de formule XIVa:

$$OCN{-}R^1{-}NCO \quad (XIV), \qquad OCN{-}R'^1{-}NCO \quad (XIVa),$$

dans un solvant inerte, à une température de 50 à 150°C (dans les formules mentionnées les symboles Q, $R^1$ et $R'^1$ ont les significations qui leur ont été données à la revendication 1).

12. Procédé pour préparer des composés répondant à la formule XIII:

$$H_2N-R^1-NH_2 \qquad (XIII)$$

dans laquelle $R^1$ a la signification qui lui a été donnée à la revendication 1, procédé qui comprend les étapes suivantes:

i) on réduit la dinitro-1,4, -1,5 ou -1,8 anthraquinone ou la diamino-1,4, -1,5 ou -1,8 anthraquinone, ou un mélange de composés de ce genre, de manière à obtenir les diaminoanthracènes correspondants ou les dihydro-9,10 anthracènes correspondants, et éventuellement:

ii) on hydrogène partiellement les diamino-anthracènes pour les convertir en les dihydro-9,10 anthracènes.

13. Produits de revêtement contenant, en solution, un polymère photosensible qui peut être obtenu selon la revendication 1, ou un mélange de polymères de ce genre.

14. Matière support revêtue d'un polymère photosensible qui peut être obtenu selon la revendication 1, ou d'un mélange de polymères de ce genre.

15. Application des polymères qui peuvent être obtenus selon la revendication 1 à la production de couches isolantes, passivantes et protectrices, d'images en relief ainsi que de feuilles stables à la chaleur.

16. Procédé pour fabriquer des revêtements et des feuilles, procédé caractérisé en ce qu'on réticule par un rayonnement de haute énergie des revêtements et des feuilles en polymères qui peuvent être obtenus selon la revendication 1.

17. Procédé de production de structures en relief, procédé caractérisé en ce qu'on expose à un rayonnement de haute énergie, conformément à une image, des revêtements en polymères qui peuvent être obtenus selon la revendication 1.